# EUROPEAN PATENT APPLICATION

(11) **EP 2 392 604 A1**
(43) Date of publication of application: **07.12.2011**
(21) Application number: 10735965.5
(22) Date of filing: 28.01.2010
(51) Int. Cl.: C08G 61/12, H01L 51/50

(54) **HIGH-MOLECULAR COMPOUND AND LIGHT-EMITTING ELEMENT USING SAME**

(30) Priority: 29.01.2009 JP 2009017858
(71) Applicant: Sumitomo Chemical Company, Limited, Tokyo 104-8260 (JP)
(72) Inventor: FUKUSHIMA, Daisuke, Ushiku-shi Ibaraki 300-1207 (JP); GOTO, Osamu, Tsukuba-shi Ibaraki 305-0821 (JP); ASADA, Kohei, Tsukuba-shi Ibaraki 305-0821 (JP); AKINO, Nobuhiko, Tsukuba-shi Ibaraki 305-0047 (JP)
(74) Representative: Duckworth, Timothy John
(86) International application number: PCT/JP2010/051551
(87) International publication number: WO 2010/087510

(57) **Abstract**

A polymer compound having a repeating unit represented by the following formula (1): 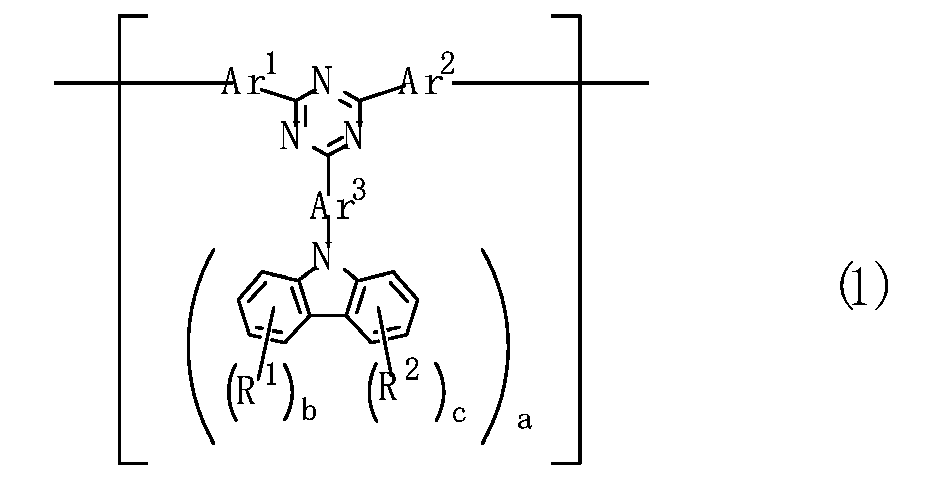 (wherein Ar¹ and Ar² represent an arylene group or a di-valent aromatic heterocyclic group, Ar³ represents a single bond, an unsubstituted or substituted (a+1)-valent aromatic hydrocarbon group or (a+1)-valent aromatic heterocyclic group. R¹ and R² represent an alkyl group, an alkoxy group, an aryl group, an aryloxy group, a mono-valent heterocyclic group, an amino group, a silyl group, a halogen atom, a carboxyl group or a cyano group. a represents an integer of 1 or more, with the proviso that a is 1 when Ar³ is a single bond. b and c represent an integer of 0 to 4.).

## Description

### Technical Field

The present invention relates to a polymer compound and a light emitting device using the same.

### Background Art

Light emitting devices such as an organic electroluminescent device and the like are suitable for display use and paid to attention. For production of this light emitting device, light emitting materials and charge transporting materials are used. As the light emitting material and charge transporting material, polymer compounds capable of forming an organic layer by an application method are investigated, and as such a polymer compound, a polymer compound having a fluorenediyl group and a phenylene group is known (Japanese Unexamined Patent Application Publication (JP-A) No. 2002-161130).

### Disclosure of the Invention

The organic electroluminescent device fabricated by using the above-described polymer compound, however, has no sufficiently long luminance half life.

The present invention has an object of providing a polymer compound which gives, when used in fabrication of an organic electroluminescent device, a long luminance half life to the resultant organic electroluminescent device.

The present invention provides, in a first aspect, a polymer compound having a repeating unit represented by the following formula (1). 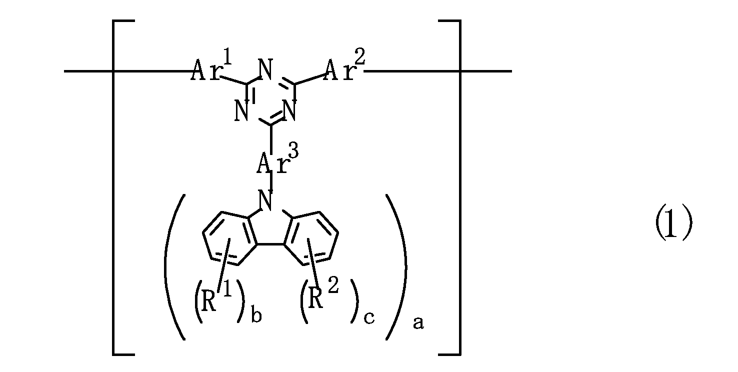 (wherein Ar¹ and Ar² represent each independently an unsubstituted or substituted arylene group or an unsubstituted or substituted di-valent aromatic heterocyclic group, Ar³ represents a single bond, an unsubstituted or substituted (a+1)-valent aromatic hydrocarbon group or an unsubstituted or substituted (a+1)-valent aromatic heterocyclic group. R¹ and R² represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. a represents an integer of 1 or more, with the proviso that a is 1 when Ar³ is a single bond. b and c represent each independently an integer of 0 to 4. When there exist a plurality of R¹s, these may be the same or different. When there exist a plurality of R²s, these may be the same or different. When there exist a plurality of b's, these may be the same or different. When there exist a plurality of c's, these may be the same or different.).

The present invention provides, in a second aspect, a composition comprising at least one material selected from the group consisting of a hole transporting material, an electron transporting material and a light emitting material, and the above-described polymer compound.

The present invention provides, in a third aspect, a solution comprising the above-described polymer compound and a solvent.

The present invention provides, in a fourth aspect, a film comprising the above-described polymer compound.

The present invention provides, in a fifth aspect, a light emitting device having electrodes consisting of an anode and a cathode, and an organic layer containing the above-described polymer compound disposed between the electrodes.

The present invention provides, in a sixth aspect, a method of producing a polymer compound having a repeating unit represented by the above-described formula (1), comprising condensation-polymerizing a compound represented by the following formula (a). 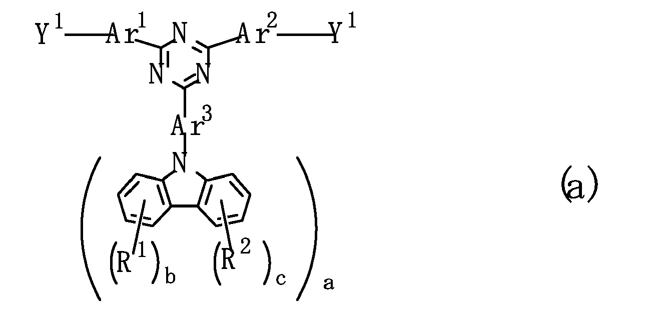 (wherein Ar¹ and Ar² represent each independently an unsubstituted or substituted arylene group or an unsubstituted or substituted di-valent aromatic heterocyclic group, Ar³ represents a single bond, an unsubstituted or substituted (a+1)-valent aromatic hydrocarbon group or an unsubstituted or substituted (a+1)-valent aromatic heterocyclic group. R¹ and R² represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. a represents an integer of 1 or more, with the proviso that a is 1 when Ar³ is a single bond. b and c represent each independently an integer of 0 to 4. When there exist a plurality of R¹s, these may be the same or different. When there exist a plurality of R²s, these may be the same or different. When there exist a plurality of bs, these may be the same or different. When there exist a plurality of cs, these may be the same or different. Y¹ represents a halogen atom, a methoxy group, a borate residue, a boric acid residue, a group represented by the following formula (a-1), a group represented by the following formula (a-2), a group represented by the following formula (a-3) or a group represented by the following formula (a-4). A plurality of Y¹s may be the same or different.) 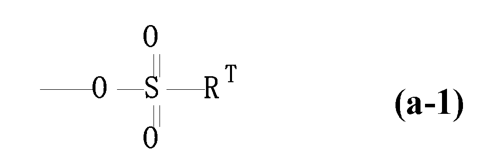 (wherein R^{T} represents an unsubstituted or substituted alkyl group or an unsubstituted or substituted aryl group.)

-MgX_{A} (a-2)

(wherein X_{A} represents a halogen atom.)

ZnX_{A} **(a-3)**

(wherein X_{A} represents the same meaning as described above.)

Sn(R^{T})₃ **(a-4)**

(wherein R^{T} represents the same meaning as described above. A plurality of R^{T}s may be mutually the same or different.)

The present invention provides, in a seventh aspect, a compound represented by the following formula (a'). 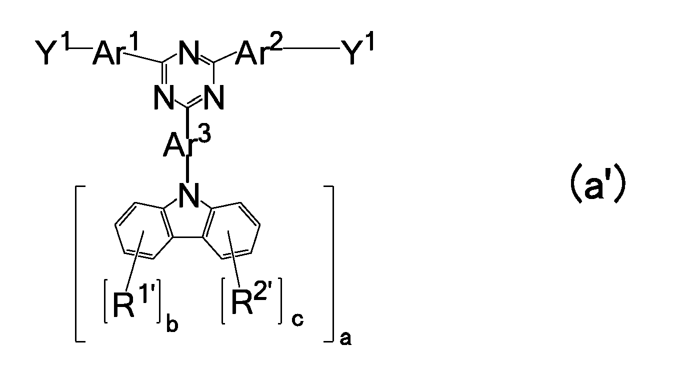 (wherein Ar¹ and Ar² represent each independently an unsubstituted or substituted arylene group or an unsubstituted or substituted di-valent aromatic heterocyclic group, Ar³ represents a single bond, an unsubstituted or substituted (a+1)-valent aromatic hydrocarbon group or an unsubstituted or substituted (a+1)-valent aromatic heterocyclic group. R¹' and R²' represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a chlorine atom, a bromine atom, an iodine atom, an unsubstituted or substituted carboxyl group or a cyano group. a represents an integer of 1 or more, with the proviso that a is 1 when Ar³ is a single bond. b and c represent each independently an integer of 0 to 4. When there exist a plurality of R¹'s, these may be the same or different. When there exist a plurality of R^{2'} these may be the same or different. When there exist a plurality of bs, these may be the same or different. When there exist a plurality of cs, these may be the same or different. Y¹ represents a halogen atom, a methoxy group, a borate residue, a boric acid residue, a group represented by the above-described formula (a-1), a group represented by the above-described formula (a-2), a group represented by the above-described formula (a-3) or a group represented by the above-described formula (a-4). A plurality of Y¹s may be the same or different.).

### Modes for Carrying Out the Invention

The present invention will be illustrated in detail below.

In the present specification, "n-valent heterocyclic group" (n is 1 or 2) means a group obtained by removing n hydrogen atoms from a heterocyclic compound (particularly, a heterocyclic compound having an aromatic property). "Heterocyclic compound" includes organic compounds having a cyclic structure in which atoms constituting the ring include not only a carbon atom but also a hetero atom such as oxygen, sulfur, nitrogen, phosphorus, boron and the like contained in the ring.

In the present specification, "arylene group" means an atomic group obtained by removing two hydrogen atoms from an aromatic hydrocarbon.

### <Polymer Compound>

### -Repeating unit represented by the formula (1)-

The polymer compound of the present invention has a repeating unit represented by the above-described formula (1).

In the above-described formula (1), Ar¹ and Ar² represent each independently an unsubstituted or substituted arylene group or an unsubstituted or substituted di-valent aromatic heterocyclic group, preferably an unsubstituted or substituted arylene group, more preferably an unsubstituted or substituted phenylene group, further preferably an unsubstituted phenylene group.

The unsubstituted or substituted arylene group represented by Ar¹ and Ar² has a carbon atom number of usually 6 to 60, preferably 6 to 18, more preferably 6 to 10, further preferably 6. This carbon atom number does not include the carbon atom number of the substituent. The arylene group includes phenylene groups such as a 1,4-phenylene group, a 1,3-phenylene group, a 1,2-phenylene group and the like; naphthalenediyl groups such as a 1,4-naphthalenediyl group, a 1,5-naphthalenediyl group, a 2,6-naphthalenediyl group and the like; anthracenediyl groups such as a 1,4-anthracenediyl group, a 1,5-anthracenediyl group, a 2,6-anthracenediyl group, a 9,10-anthracenediyl group and the like; phenanthrenediyl groups such as a 2,7-phenanthrenediyl group and the like; naphthacenediyl groups such as a 1,7-naphthacenediyl group, a 2,8-naphthacenediyl group, a 5,12-naphthacenediyl group and the like; fluorenediyl groups such as a 2,7-fluorenediyl group and the like, preferably a 1,4-phenylene group, a 1,3-phenylene group, a 1,2-phenylene group, a 1,4-naphthalenediyl group and a 2,6- naphthalenediyl group, more preferably a 1,4-phenylene group, a 1,3-phenylene group and a 1,2-phenylene group, further preferably a 1,4-phenylene group.

The unsubstituted or substituted di-valent aromatic heterocyclic group represented by Ar¹ and Ar² has a carbon atom number of usually 3 to 60, preferably 3 to 20, more preferably 3 to 9, further preferably 3 to 5. The di-valent aromatic heterocyclic group includes thiophenediyl groups such as a 2,5-thiophenediyl group and the like, pyrrolediyl groups such as an N-methyl-2,5-pyrrolediyl group and the like, furandiyl groups such as a 2,5-furandiyl group and the like, pyridinediyl groups such as a 2,5-pyridinediyl group, a 2,6-pyridinediyl group and the like, quinolinediyl groups such as a 2,4-quinolinediyl group, a 2,6-quinolinediyl group and the like, isoquinolinediyl groups such as a 1,4-isoquinolinediyl group, a 1,5-isoquinolinediyl group and the like, and quinoxalinediyl groups such as a 5,8-quinoxalinediyl group and the like, preferably a 2,5-thiophenediyl group, a 2,5-pyridinediyl group, a 2,6-pyridinediyl group, a 2,4-quinolinediyl group, a 2,6-quinolinediyl group, a 1,4-isoquinolinediyl group and a 1,5-isoquinolinediyl group, more preferably a 2,5-pyridinediyl group, a 2,6-pyridinediyl group and a 1,4-isoquinolinediyl group, further preferably a 2,5-pyridinediyl group and a 2,6-pyridinediyl group.

In the unsubstituted or substituted di-valent aromatic heterocyclic group represented by Ar¹ and Ar² in the formula (1), it is preferable that a carbon atom contained in this group is linked to a carbon atom contained in an adjacent triazine ring.

When the arylene group or di-valent aromatic heterocyclic group represented by Ar¹ and Ar² has a substituent, the substituent is preferably an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group, more preferably an unsubstituted or substituted alkyl group, an unsubstituted or substituted alkoxy group, an unsubstituted or substituted aryl group or an unsubstituted or substituted mono-valent heterocyclic group, further preferably an unsubstituted or substituted alkyl group or an unsubstituted or substituted aryl group, particularly preferably an unsubstituted or substituted alkyl group.

The unsubstituted or substituted alkyl group may be any of linear, branched or cyclic, and has a carbon atom number of usually 1 to 20, preferably 1 to 15, more preferably 1 to 10. This carbon atom number does not include the carbon atom number of the substituent. The unsubstituted or substituted alkyl group includes unsubstituted alkyl groups such as a methyl group, an ethyl group, a n-propyl group, an i-propyl group, a n-butyl group, a s-butyl group, an i-butyl group, a t-butyl group, a n-pentyl group, an isoamyl group, a n-hexyl group, a cyclohexyl group, a n-heptyl group, a n-octyl group, a 2-ethylhexyl group, a n-nonyl group, a n-decyl group, a 3,7-dimethyloctyl group, a n-lauryl group and the like; and substituted alkyl groups such as a trifluoromethyl group, a pentafluoroethyl group, a perfluorobutyl group, a perfluorohexyl group, a perfluorooctyl group, a phenylmethyl group, a 4-(4-hexylphenyl)butyl group, a phenoxymethyl group, a 4-(4-hexylphenyloxy)butyl group and the like, and preferable from the standpoint of a balance between the heat resistance and the solubility into an organic solvent of the resultant polymer compound, and the like are a methyl group, an ethyl group, a n-propyl group, an i-propyl group, a n-butyl group, an i-butyl group, a t-butyl group, a n-pentyl group, an isoamyl group, a n-hexyl group, a n-octyl group, a 2-ethylhexyl group, a n-decyl group and a 3,7-dimethyloctyl group.

The unsubstituted or substituted alkoxy group may be any of linear, branched or cyclic, and has a carbon atom number of usually 1 to 20, preferably 1 to 15. This carbon atom number does not include the carbon atom number of the substituent. The above-described an unsubstituted or substituted alkoxy group includes a methoxy group, an ethoxy group, a n-propyloxy group, an i-propyloxy group, a n-butyloxy group, an i-butyloxy group, a t-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group, a lauryloxy group, a trifluoromethoxy group, a pentafluoroethoxy group, a perfluorobutoxy group, a perfluorohexyl group, a perfluorooctyl group, a methoxymethyloxy group, a 2-methoxyethyloxy group, a 2-ethoxyethyloxy group and the like, and preferable from the standpoint of a balance between the heat resistance and the solubility into an organic solvent of the resultant polymer compound, and the like are a n-butyloxy group, a n-pentyloxy group, a n-hexyloxy group, a n-octyloxy group, a 2-ethylhexyloxy group, a n-decyloxy group and a 3,7-dimethyloctyloxy group.

The unsubstituted or substituted aryl group is an atomic group obtained by removing one hydrogen atom from an aromatic hydrocarbon, and includes those having a condensed ring, and those having two or more independent benzene rings or condensed rings linked directly or via a group such as vinylene and the like. The above-described unsubstituted or substituted aryl group has a carbon atom number of usually 6 to 60, preferably 6 to 48, more preferably 6 to 20, further preferably 6 to 10. This carbon atom number does not include the carbon atom number of the substituent. The unsubstituted or substituted aryl group includes a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-perylenyl group, a 3-perylenyl group, a 2-fluorenyl group, a 3-fluorenyl group, a 4-fluorenyl group, a 1-biphenylenyl group, a 2-biphenylenyl group, a 2-phenanthrenyl group, a 9-phenanthrenyl group, a 2-phenylphenyl group, a 3-phenylphenyl group and a 4-phenylphenyl group, and those obtained by further substitution on these groups by an alkyl group, an alkoxy group, an alkyloxycarbonyl group, an acyl group, an N,N-dialkylamino group, an N,N-diarylamino group, a cyano group, a nitro group, a chlorine atom, a fluorine atom or the like, and preferable from the standpoint of a balance between the heat resistance and the solubility into an organic solvent of the resultant polymer compound, and the like are a phenyl group and phenyl groups substituted by an alkyl group.

The phenyl group substituted by an alkyl group includes a 2-methylphenyl group, a 3-methylphenyl group, a 4-methylphenyl group, a 3-n-butylphenyl group, a 4-n-butylphenyl group, a 4-t-butylphenyl group, a 3-n-hexylphenyl group, a 4-n-hexylphenyl group, a 4-n-octylphenyl group, a 3,5-dimethylphenyl group, a 3-n-hexyl-5-methylphenyl group, a 3,5-dihexylphenyl group and the like.

The unsubstituted or substituted aryloxy group has a carbon atom number of usually 6 to 60, preferably 7 to 48. This carbon atom number does not include the carbon atom number of the substituent. The above-described unsubstituted or substituted aryloxy group includes a phenoxy group, a 1-naphthyloxy group, a 2-naphthyloxy group, a 1-anthracenyloxy group, a 9-anthracenyloxy group, a 1-pyrenyloxy group, and those obtained by further substitution on these groups by an alkyl group, an alkoxy group, an alkyloxycarbonyl group, an acyl group, an N,N-dialkylamino group, an N,N-diarylamino group, a cyano group, a nitro group, a chlorine atom, a fluorine atom or the like.

The unsubstituted or substituted mono-valent heterocyclic group has a carbon atom number of usually 4 to 60, preferably 4 to 20. This carbon atom number does not include the carbon atom number of the substituent. The unsubstituted or substituted mono-valent heterocyclic group includes a thienyl group, a pyrrolyl group, a furyl group, a pyridyl group, a piperidyl group, a quinolyl group, an isoquinolyl group, a pyrimidyl group, a triazinyl group and the like, and those obtained by further substitution on these groups by an alkyl group, an alkoxy group or the like, as examples, and preferably a thienyl group, a pyridyl group, a quinolyl group, an isoquinolyl group, a pyrimidyl group and a triazinyl group, and those obtained by further substitution on these groups by an alkyl group, an alkoxy group or the like, more preferably a pyridyl group, a pyrimidyl group and a triazinyl group, and those obtained by further substitution on these groups by an alkyl group, an alkoxy group or the like.

The substituted amino group includes amino groups substituted by one or two groups selected from the group consisting of an alkyl group, an aryl group and a mono-valent heterocyclic group. The definitions and examples of the alkyl group, aryl group and mono-valent heterocyclic group are the same as described above. The above-described substituted amino group has a carbon atom number of usually 1 to 50, preferably 2 to 30, more preferably 12 to 24. The substituted amino group includes a methylamino group, a dimethylamino group, a di-n-propylamino group, a diisopropylamino group, a di-n-butylamino group, a di-t-butylamino group, a dicyclohexylamino group, a di-n-octylamino group, a phenylamino group, a diphenylamino group, a di-1-naphthylamino group, a di-2-naphthylamino group, a di-2-pyridylamino group, a dipyrimidylamino group, a dipyrazylamino group, a di(triazyl)amino group and a di-(4-phenylphenyl)amino group, and those obtained by further substitution on these groups by an alkyl group, an alkoxy group, an aryl group, an alkyloxycarbonyl group, an acyl group, an N,N-dialkylamino group, an N,N-diarylamino group, a cyano group, a nitro group, a chlorine atom, a fluorine atom or the like.

The substituted silyl group includes silyl groups substituted by 1 to 3 groups selected from the group consisting of an alkyl group, an aryl group and a mono-valent heterocyclic group. The definitions and examples of the alkyl group, aryl group and mono-valent heterocyclic group are the same as described above. The substituted silyl group has a carbon atom number of usually 1 to 60, preferably 3 to 48. The substituted silyl group includes a trimethylsilyl group, a triethylsilyl group, a tri-n-propylsilyl group, a tri-i-propylsilyl group, a dimethyl-i-propylsilyl group, a t-butyldimethylsilyl group, a triphenylsilyl group, a tri-p-xylylsilyl group, a tribenzylsilyl group, a diphenylmethylsilyl group, a t-butyldiphenylsilyl group, a dimethylphenylsilyl group and the like.

The halogen atom includes a fluorine atom, a chlorine atom, a bromine atom and an iodine atom.

The substituted carboxyl group includes carboxyl groups substituted by an alkyl group, an aryl group or a mono-valent heterocyclic group. The definitions and examples of the alkyl group, aryl group and mono-valent heterocyclic group are the same as described above. The substituted carboxyl group has a carbon atom number of usually 2 to 60, preferably 2 to 20. The substituted carboxyl group include a methoxycarbonyl group, an ethoxycarbonyl group, a n-propyloxycarbonyl group, an i-propyloxycarbonyl group, a n-butyloxycarbonyl group, a t-butyloxycarbonyl group, a phenoxycarbonyl group, a naphthoxycarbonyl group, a pyridyloxycarbonyl group, and those obtained by further substitution on the groups by an alkyl group, an alkoxy group, an aryl group, an alkyloxycarbonyl group, an acyl group, an N,N-dialkylamino group, an N,N-diarylamino group, a cyano group, a nitro group, a chlorine atom, a fluorine atom or the like.

In the formula (1), Ar³ represents a single bond, an unsubstituted or substituted (a+1)-valent aromatic hydrocarbon group or an unsubstituted or substituted (a+1)-valent aromatic heterocyclic group, and from the standpoint of the luminance half life, efficiency and the like of a light emitting device, represents preferably a single bond, an unsubstituted or substituted (a+1)-valent aromatic hydrocarbon group, more preferably a single bond.

In the formula (1), a represents an integer of 1 or more, preferably an integer of 1 to 5, more preferably 1 or 2, further preferably 1.

The (a+1)-valent aromatic hydrocarbon group means an atomic group obtained by removing (a+1) hydrogen atoms from an aromatic hydrocarbon. The aromatic hydrocarbon has a carbon atom number of usually 6 to 60, preferably 6 to 18, more preferably 6 to 10, further preferably 6. This carbon atom number does not include the carbon atom number of the substituent. The aromatic hydrocarbon includes benzene, naphthalene, anthracene, pyrene, fluorene and the like, preferably benzene and naphthalene, more preferably benzene.

The (a+1)-valent aromatic heterocyclic group means an atomic group obtained by removing (a+1) hydrogen atoms from an aromatic heterocyclic compound. The aromatic heterocyclic compound has a carbon atom number of usually 3 to 60, preferably 3 to 20, more preferably 3 to 9, further preferably 3 to 5. This carbon atom number does not include the carbon atom number of the substituent. The aromatic heterocyclic compound includes thiophene, pyrrole, furane, pyridine, pyrimidine, triazine, quinoline, isoquinoline, quinoxaline and the like, preferably pyridine, pyrimidine and triazine, more preferably pyridine.

When Ar³ has a substituent, the definitions and examples of this substituent are the same as in the explanation of the substituent which can be carried on Ar¹ and Ar² _{.}

In the formula (1), R¹ and R² represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. The definitions and examples of these groups and atoms are the same as in the explanation of the substituent which can be carried on Ar¹ and Ar². From the standpoint of a balance between the heat resistance and the solubility into an organic solvent of the resultant polymer compound, and the like, R¹ and R² represent preferably an unsubstituted or substituted alkyl group, an unsubstituted or substituted alkoxy group, an unsubstituted or substituted aryl group or an unsubstituted or substituted mono-valent heterocyclic group, more preferably an unsubstituted alkyl group, an unsubstituted alkoxy group, a substituted aryl group or a substituted mono-valent heterocyclic group, further preferably an unsubstituted alkyl group or a substituted aryl group. The substituted aryl group is preferably a phenyl group substituted by an alkyl group.

In the formula (1), b and c represent each independently an integer of 0 to 4, preferably 1 or 2, more preferably 1.

From the standpoint of the luminance half life, efficiency and the like when the polymer compound of the present invention is used for fabrication of a light emitting device, the repeating unit represented by the formula (1) is preferably a repeating unit represented by the following formula (4): 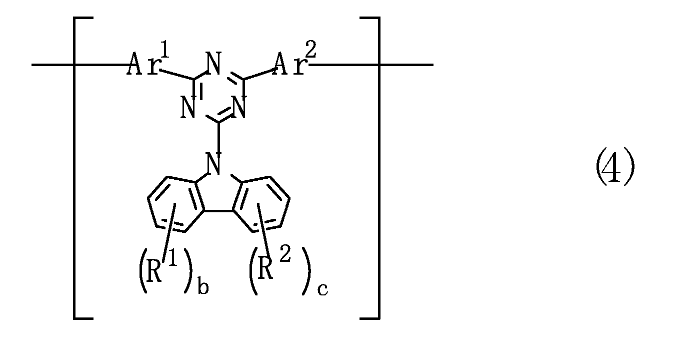 (wherein Ar¹ Ar², R¹, R², b and c have the same meaning as described above.)
, more preferably a repeating unit represented by the following formula (5): 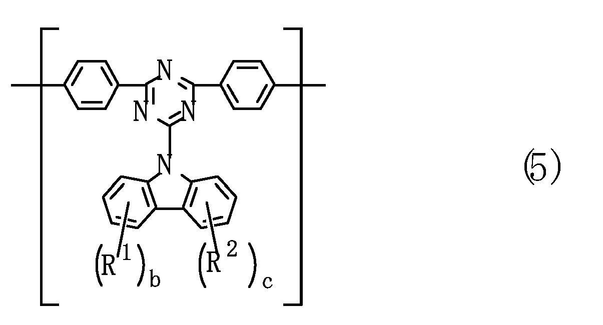 (wherein R¹, R², b and c have the same meaning as described above.).

The repeating unit represented by the formula (1) includes repeating units represented by the following formulae (1-1) to (1-39), and from the standpoint of the luminance half life of the resultant light emitting device, includes preferably repeating units represented by the following formulae (1-1) to (1-36), more preferably repeating units represented by the following formulae (1-1) to (1-31), further preferably repeating units represented by the formulae (1-1) to (1-18) and (1-27) to (1-31), particularly preferably repeating units represented by the formulae (1-1) to (1-18), especially preferably repeating units represented by the formulae (1-1) to (1-7) and (1-10) to (1-13).

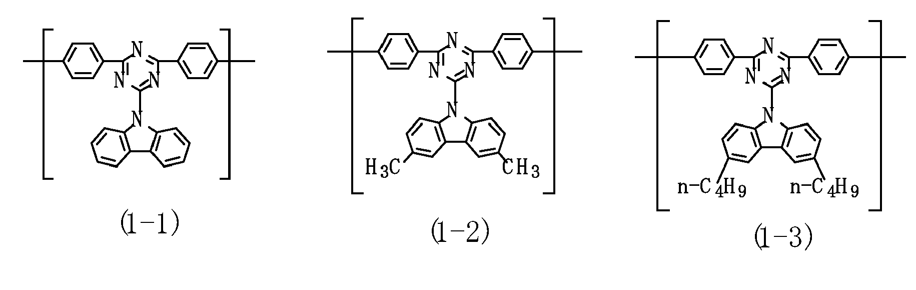

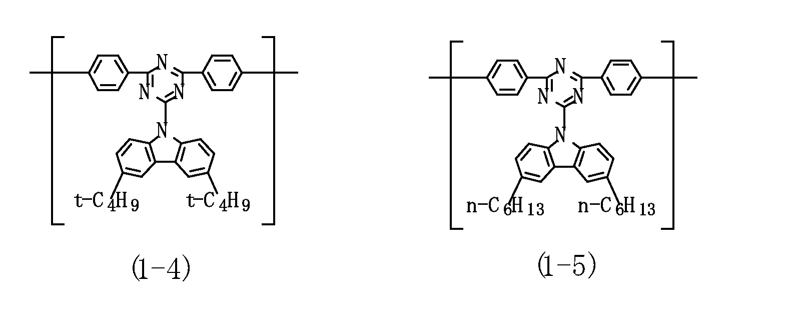

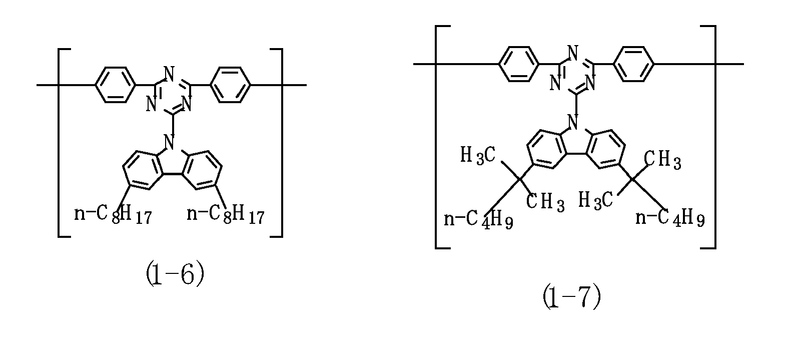

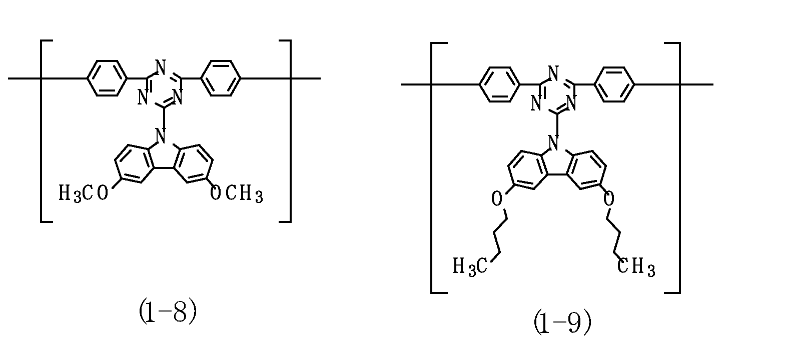

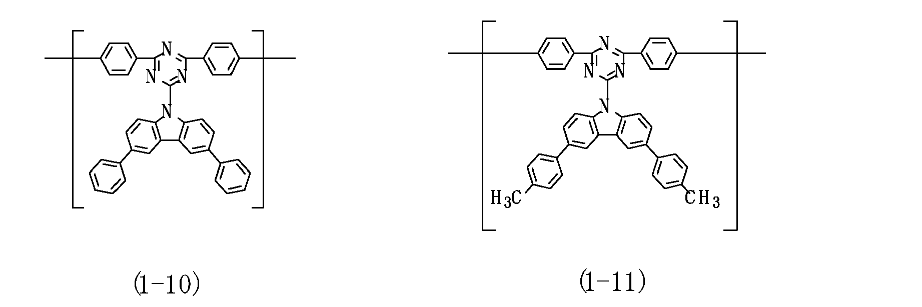

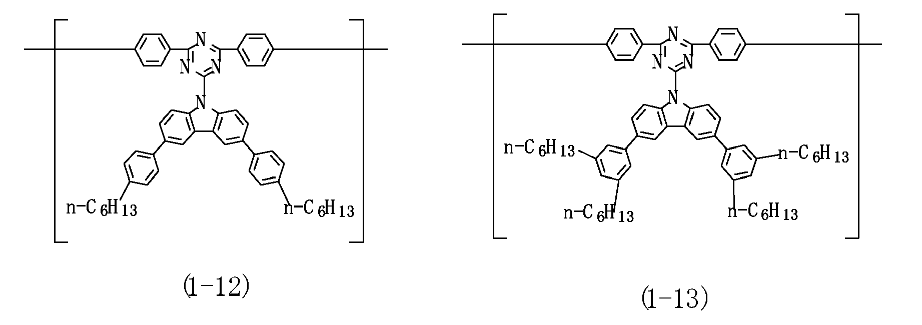

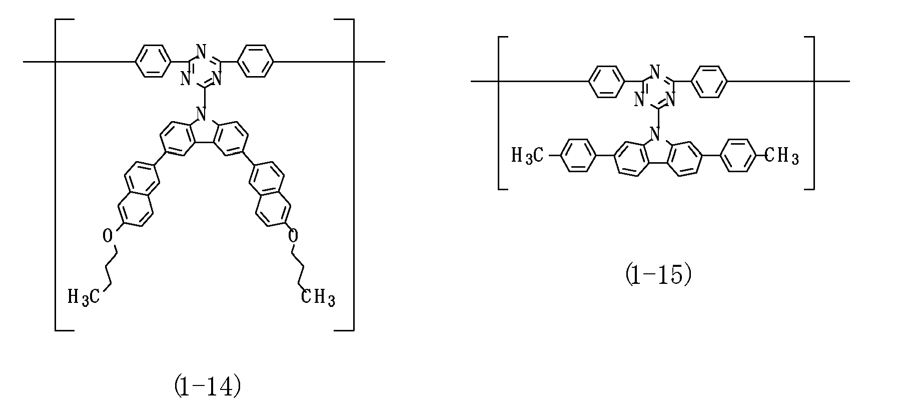

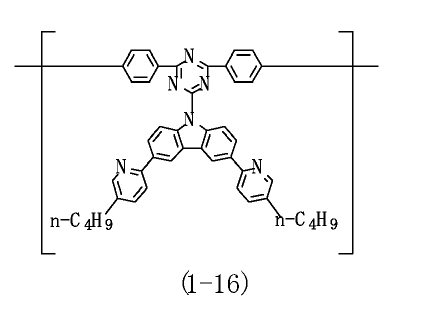

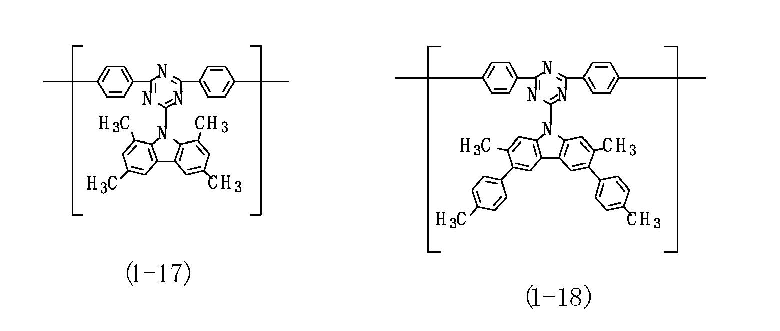

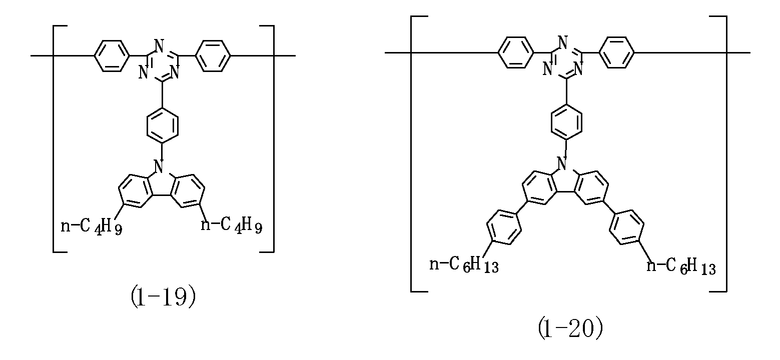

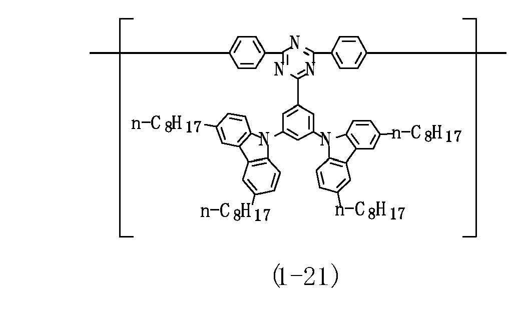

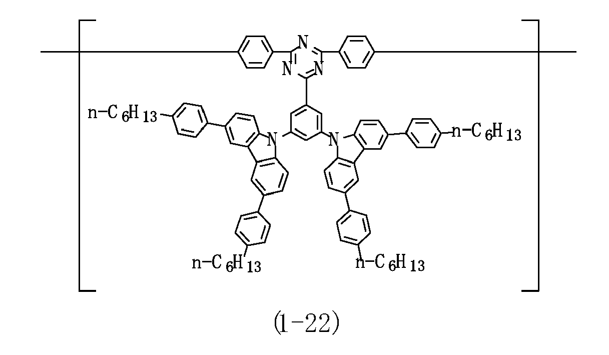

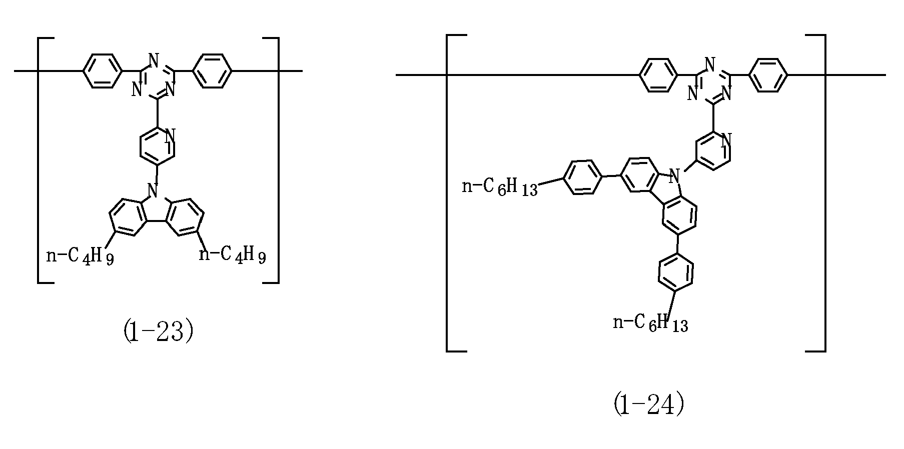

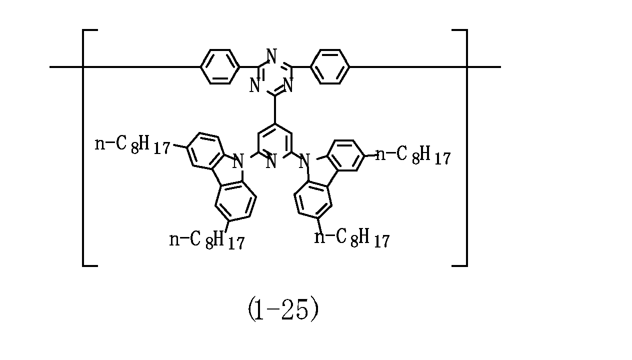

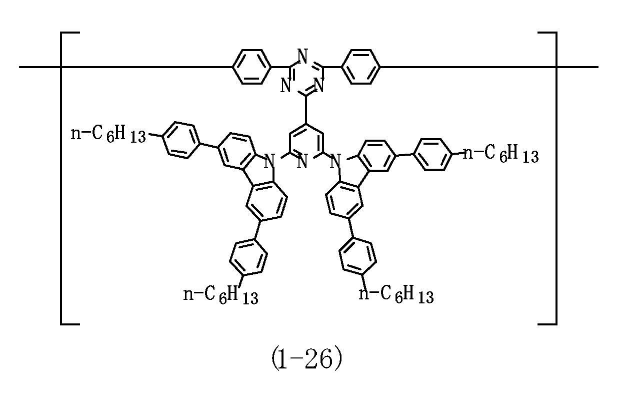

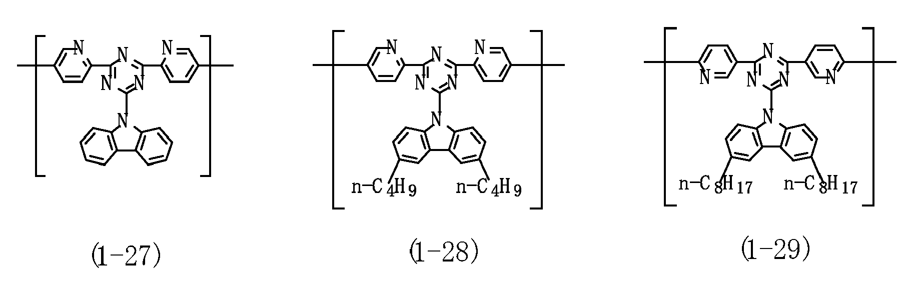

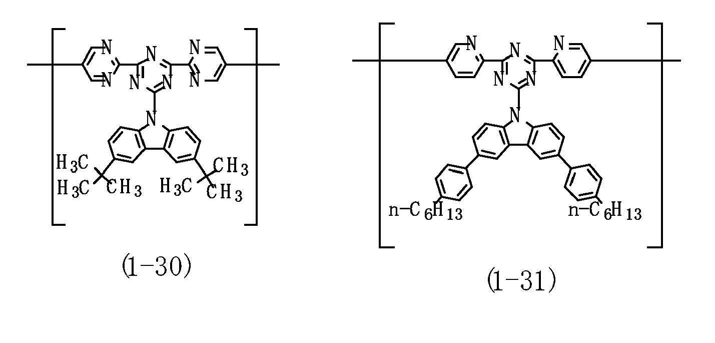

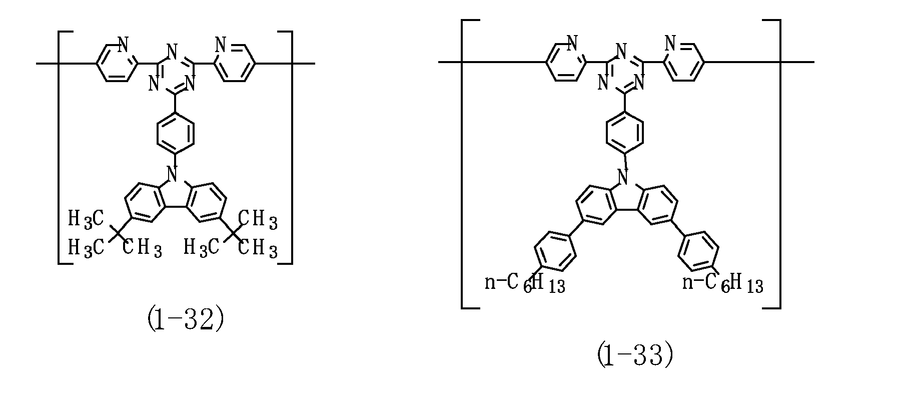

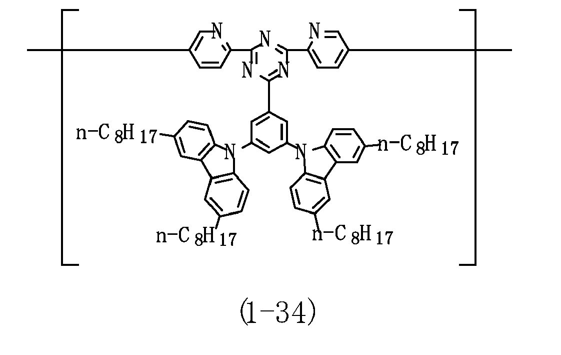

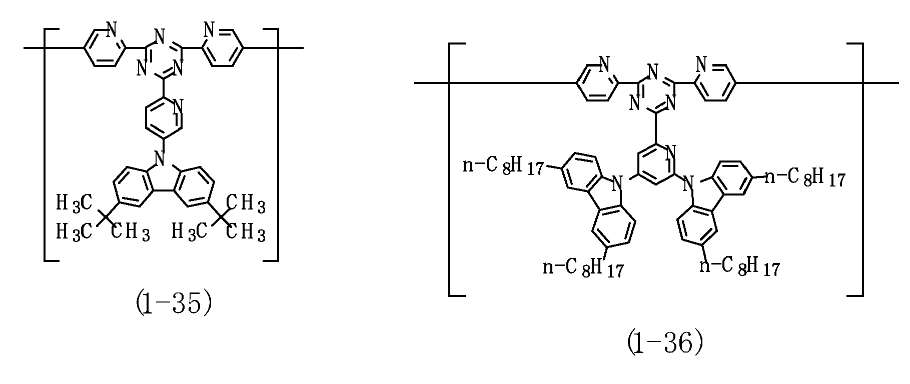

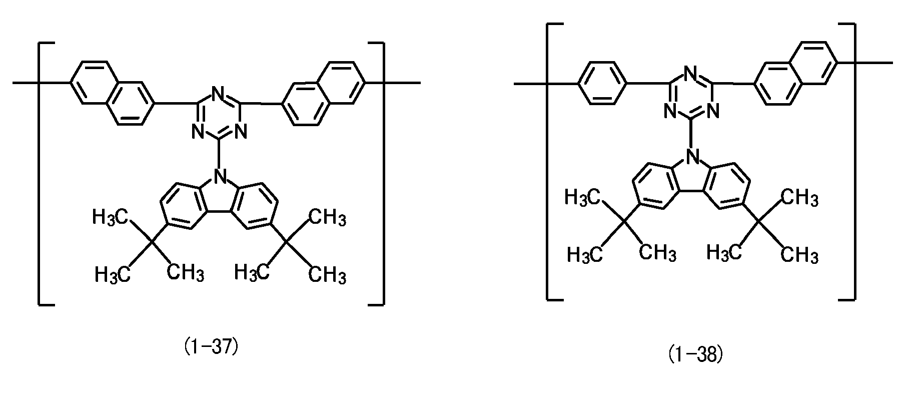

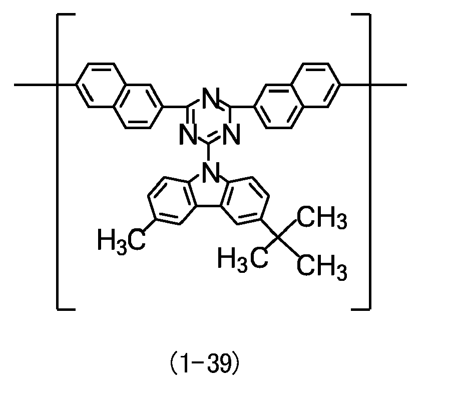

The repeating units represented by the formula (1) may be contained singly or in combination of two or more.

It is preferable for the polymer compound of the present invention, from the standpoint of the luminance half life when the polymer compound is used for fabrication of a light emitting device, and the like, to further contain at least one repeating unit selected from the group consisting of a repeating unit represented by the following formula (2) and a repeating unit represented by the following formula (3).

-(Ar⁴)- (2)

(wherein Ar⁴ represents an unsubstituted or substituted arylene group or an unsubstituted or substituted di-valent aromatic heterocyclic group.) 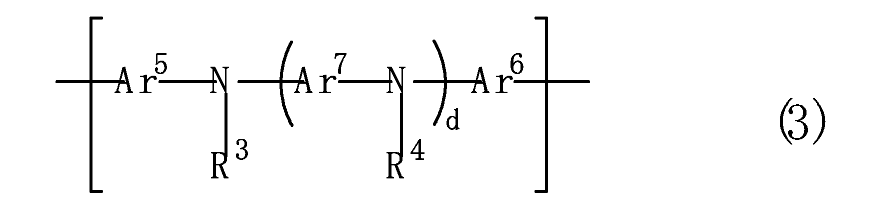 (wherein Ar⁵, Ar⁶ and Ar⁷ represent each independently an unsubstituted or substituted arylene group, an unsubstituted or substituted di-valent aromatic heterocyclic group or an unsubstituted or substituted di-valent group composed of two aromatic rings linked via a single bond. R³ and R⁴ represent each independently a hydrogen atom, an unsubstituted or substituted alkyl group, an unsubstituted or substituted aryl group or an unsubstituted or substituted mono-valent heterocyclic group. d represents 0 or 1.).

### -Repeating unit represented by the formula (2)-

In the formula (2), Ar⁴ represents an unsubstituted or substituted arylene group or an unsubstituted or substituted di-valent aromatic heterocyclic group. Here, the repeating unit represented by the above-described formula (2) is different from the repeating unit represented by the above-described formula (1).

The unsubstituted or substituted arylene group represented by Ar⁴ has a carbon atom number of usually 6 to 60, preferably 6 to 30, more preferably 6 to 18, further preferably 7 to 14. This carbon atom number does not include the carbon atom number of the substituent. The arylene group includes unsubstituted or substituted phenylene groups such as a 1,4-phenylene group, a 1,3-phenylene group, a 1,2-phenylene group and the like; unsubstituted or substituted naphthalenediyl groups such as a 1,4-naphthalenediyl group, a 1,5-naphthalenediyl group, a 2,6-naphthalenediyl group and the like; unsubstituted or substituted anthracenediyl groups such as a 1,4-anthracenediyl group, a 1,5-anthracenediyl group, a 2,6-anthracenediyl group, a 9,10-anthracenediyl group and the like; unsubstituted or substituted phenanthrenediyl groups such as a 2,7-phenanthrenediyl group and the like; unsubstituted or substituted naphthacenediyl groups such as a 1,7-naphthacenediyl group, a 2,8-naphthacenediyl group, a 5,12-naphthacenediyl group and the like; unsubstituted or substituted fluorenediyl groups such as a 2,7-fluorenediyl group, a 3,6-fluorenediyl group and the like; unsubstituted or substituted pyrenediyl groups such as a 1,6-pyrenediyl group, a 1,8-pyrenediyl group, a 2,7-pyrenediyl group, a 4,9-pyrenediyl group and the like; unsubstituted or substituted perylenediyl groups such as a 3,9-perylenediyl group, a 3,10-perylenediyl group and the like; etc., preferably an unsubstituted or substituted phenylene group, an unsubstituted or substituted naphthalenediyl group, an unsubstituted or substituted fluorenediyl group and an unsubstituted or substituted pyrenediyl group, more preferably an unsubstituted or substituted phenylene group and an unsubstituted or substituted fluorenediyl group.

The unsubstituted or substituted di-valent aromatic heterocyclic group represented by Ar⁴ has a carbon atom number of usually 4 to 60, preferably 4 to 30, more preferably 5 to 22, particularly preferably 5 to 12. This carbon atom number does not include the carbon atom number of the substituent. The di-valent aromatic heterocyclic group includes unsubstituted or substituted pyridinediyl groups such as a 2,5-pyridinediyl group, a 2,6-pyridinediyl group and the like; unsubstituted or substituted thiophenediyl groups such as a 2,5-thiophenediyl group and the like; unsubstituted or substituted furandiyl groups such as a 2,5-furandiyl group and the like; unsubstituted or substituted quinolinediyl groups such as a 2,6-quinolinediyl group and the like; unsubstituted or substituted isoquinolinediyl groups such as a 1,4-isoquinolinediyl group, 1,5-isoquinolinediyl group and the like; unsubstituted or substituted quinoxalinediyl groups such as a 5,8-quinoxalinediyl group and the like; unsubstituted or substituted benzo[1,2,5]thiadiazolediyl groups such as a 4,7-benzo[1,2,5]thiadiazolediyl group and the like; unsubstituted or substituted benzothiazolediyl groups such as a 4,7-benzothiazolediyl group and the like; unsubstituted or substituted carbazolediyl groups such as a 2,7-carbazolediyl group, a 3,6-carbazolediyl group and the like; unsubstituted or substituted phenoxazinediyl groups such as a 3,7-phenoxazinediyl group and the like; unsubstituted or substituted phenothiazinediyl groups such as a 3,7-phenothiazinediyl group and the like; unsubstituted or substituted dibenzosilolediyl groups such as a 2,7-dibenzosilolediyl group and the like; etc., preferably an unsubstituted or substituted thiophenediyl group, an unsubstituted or substituted benzo[1,2,5]thiadiazolediyl group and an unsubstituted or substituted phenoxazinediyl group, more preferably an unsubstituted or substituted benzo[1,2,5]thiadiazolediyl group and an unsubstituted or substituted phenoxazinediyl group.

When arylene group or di-valent aromatic heterocyclic group has a substituent, the substituent is preferably an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group, more preferably an unsubstituted or substituted alkyl group, an unsubstituted or substituted alkoxy group, an unsubstituted or substituted aryl group or an unsubstituted or substituted mono-valent heterocyclic group, particularly preferably an unsubstituted or substituted alkyl group or an unsubstituted or substituted aryl group. The definitions and examples of the unsubstituted or substituted alkyl group, unsubstituted or substituted alkoxy group, unsubstituted or substituted aryl group, unsubstituted or substituted aryloxy group, unsubstituted or substituted mono-valent heterocyclic group, substituted amino group, substituted silyl group, halogen atom and substituted carboxyl group are the same as described above.

From the standpoint of the luminance half life and the like when the polymer compound is used for fabrication of a light emitting device, Ar⁴ in the formula (2) is preferably a di-valent group represented by the following formula (6), (7), (8), (9) or (10), more preferably a di-valent group represented by the following formula (6), (7) or (8). 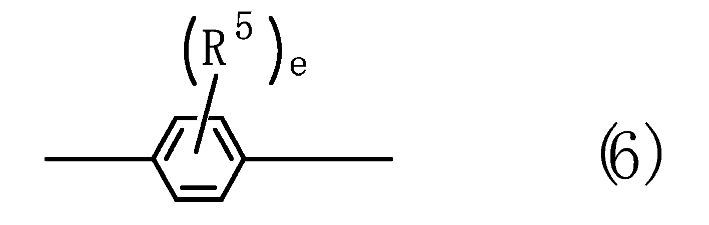 (wherein R⁵ represents an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. e represents an integer of 0 to 4. When there exist a plurality of R⁵s, these may be the same or different.) 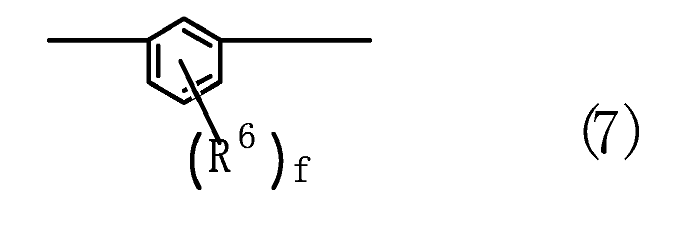 (wherein R⁶ represents an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. f represents an integer of 0 to 4. When there exist a plurality of R⁶s, these may be the same or different.) 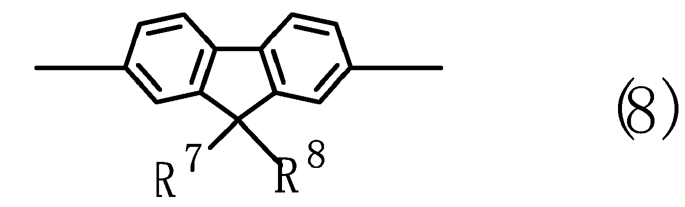 (wherein R⁷ and R⁸ represent each independently a hydrogen atom, an unsubstituted or substituted alkyl group, an unsubstituted or substituted aryl group or an unsubstituted or substituted mono-valent heterocyclic group.) 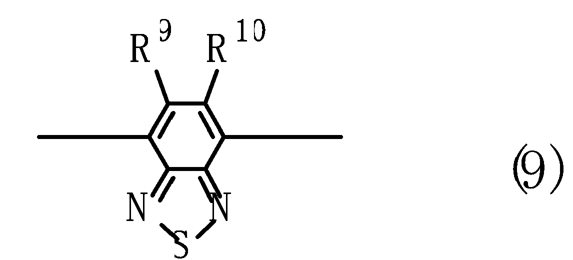 (wherein R⁹ and R¹⁰ represent each independently a hydrogen atom, an unsubstituted or substituted alkyl group, an unsubstituted or substituted alkoxy group, an unsubstituted or substituted aryl group or an unsubstituted or substituted mono-valent heterocyclic group.) 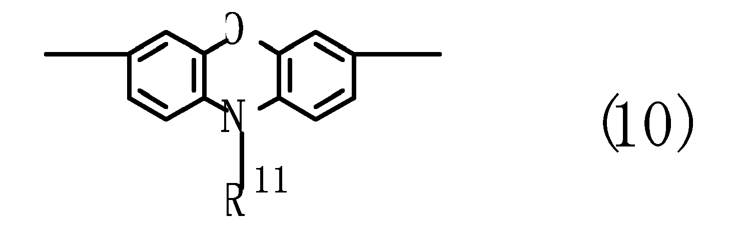 (wherein R¹¹ represents a hydrogen atom, an unsubstituted or substituted alkyl group, an unsubstituted or substituted aryl group or an unsubstituted or substituted mono-valent heterocyclic group.).

In the formula (6), R⁵ represents an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. The definitions and examples of these groups and atoms are the same as in the explanation of the substituent which can be carried on Ar¹ and Ar². R⁵ represents preferably an unsubstituted or substituted alkyl group, an unsubstituted or substituted alkoxy group, an unsubstituted or substituted aryl group or an unsubstituted or substituted mono-valent heterocyclic group, more preferably an unsubstituted or substituted alkyl group or an unsubstituted or substituted aryl group, particularly preferably an unsubstituted alkyl group.

In the formula (6), e represents an integer of 0 to 4, preferably an integer of 0 to 2, more preferably 1 or 2, further preferably 2.

In the formula (7), R⁶ represents an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. The definitions and examples of these groups and atoms are the same as in the explanation of the substituent which can be carried on Ar¹ and Ar². R⁶ represents preferably an unsubstituted or substituted alkyl group, an unsubstituted or substituted alkoxy group, an unsubstituted or substituted aryl group or an unsubstituted or substituted mono-valent heterocyclic group, more preferably an unsubstituted or substituted alkyl group or an unsubstituted or substituted aryl group, further preferably an unsubstituted alkyl group.

In the formula (7), f represents an integer of 0 to 4, preferably an integer of 0 to 2, more preferably 1 or 2, further preferably 1.

In the formula (8), R⁷ and R⁸ represent each independently a hydrogen atom, an unsubstituted or substituted alkyl group, an unsubstituted or substituted aryl group or an unsubstituted or substituted mono-valent heterocyclic group. The definitions and examples of these groups and atoms are the same as in the explanation of the substituent which can be carried on Ar¹ and Ar². R⁷ and R⁸ represent preferably an unsubstituted or substituted alkyl group or an unsubstituted or substituted aryl group, more preferably an unsubstituted alkyl group or substituted aryl group.

In the formula (9), R⁹ and R¹⁰ represent each independently a hydrogen atom, an unsubstituted or substituted alkyl group, an unsubstituted or substituted alkoxy group, an unsubstituted or substituted aryl group or an unsubstituted or substituted mono-valent heterocyclic group. The definitions and examples of these groups and atoms are the same as in the explanation of the substituent which can be carried on Ar¹ and Ar². R⁹ and R¹⁰ represent preferably an unsubstituted or substituted alkyl group or an unsubstituted or substituted aryl group, more preferably an unsubstituted alkyl group.

In the formula (10), R¹¹ represents a hydrogen atom, an unsubstituted or substituted alkyl group, an unsubstituted or substituted aryl group or an unsubstituted or substituted mono-valent heterocyclic group. The definitions and examples of these groups and atoms are the same as in the explanation of the substituent which can be carried on Ar¹ and Ar². R¹¹ represents preferably an unsubstituted or substituted alkyl group or an unsubstituted or substituted aryl group, more preferably an unsubstituted alkyl group or a substituted aryl group, further preferably a substituted aryl group.

The repeating units represented by the formula (2) may be contained singly or in combination of two or more

### -Constituent unit represented by the formula (3)-

In the formula (3), Ar⁵, Ar⁶ and Ar⁷ represent each independently an unsubstituted or substituted arylene group, an unsubstituted or substituted di-valent aromatic heterocyclic group or an unsubstituted or substituted di-valent group composed of two aromatic rings linked via a single bond, preferably an unsubstituted or substituted arylene group.

The arylene group represented by Ar⁵, Ar⁶ and Ar⁷ has a carbon atom number of usually 6 to 60, preferably 6 to 30, more preferably 6 to 18, further preferably 6 to 10, particularly preferably 6. This carbon atom number does not include the carbon atom number of the substituent. The above-described arylene group includes phenylene groups such as a 1,3-phenylene group, a 1,4-phenylene group and the like; naphthalenediyl groups such as a 1,4-naphthalenediyl group, a 2,6-naphthalenediyl group and the like; anthracenediyl groups such as a 9,10-anthracenediyl group and the like; phenanthrenediyl groups such as a 2,7-phenanthrenediyl group and the like; naphthacenediyl groups such as a 5,12-naphthacenediyl group and the like; fluorenediyl groups such as a 2,7-fluorenediyl group and the like; and perylenediyl groups such as a 3,8-perylenediyl group and the like.

The di-valent heterocyclic group represented by Ar⁵, Ar⁶ and Ar⁷ has a carbon atom number of usually 4 to 60, preferably 4 to 20, more preferably 4 to 9, further preferably 4 to 5. This carbon atom number does not include the carbon atom number of the substituent. The above-described di-valent heterocyclic group includes thiophenediyl groups such as a 2,5-thiophenediyl group and the like; pyrrolediyl groups such as an N-methyl-2,5-pyrrolediyl group and the like; furandiyl groups such as a 2,5-furandiyl group and the like; pyridinediyl groups such as a 2,5-pyridinediyl group, a 2,6-pyridinediyl group and the like; quinolinediyl groups such as a 2,4-quinolinediyl group, a 2,6-quinolinediyl group and the like; isoquinolinediyl groups such as a 1,4-isoquinolinediyl group, a 1,5-isoquinolinediyl group and the like; thiadiazolediyl groups such as a 4,7-benzo[1,2,5]thiadiazolediyl group and the like; phenoxazinediyl groups such as a 3,7-phenoxazinediyl group and the like; and carbazolediyl groups such as a 3,6-carbazolediyl group and the like.

The di-valent group composed of two aromatic rings linked via a single bond represented by Ar⁵, Ar⁶ and Ar⁷ includes groups represented by the following formulae (3A-1) to (3A-8).

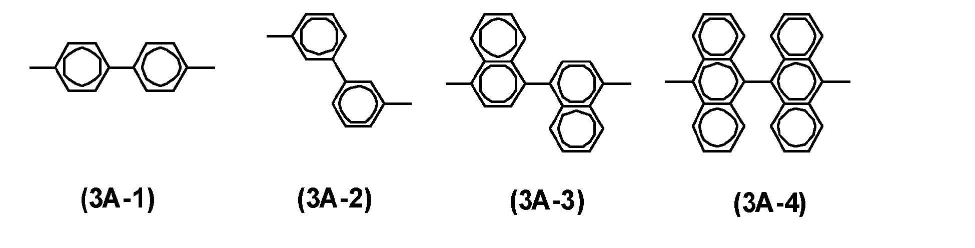

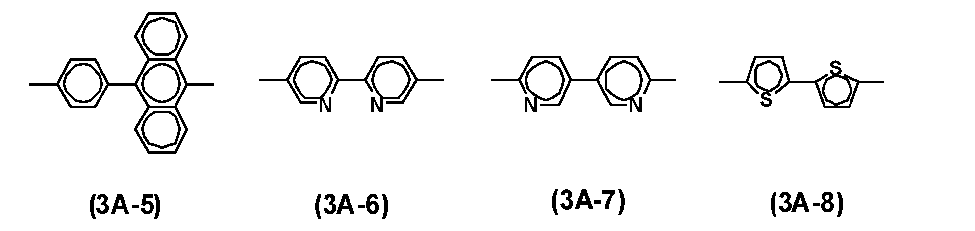

When the arylene group, di-valent aromatic heterocyclic group or di-valent group composed of two aromatic rings linked via a single bond has substituent, the substituent is preferably an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group, more preferably an unsubstituted or substituted alkyl group, an unsubstituted or substituted alkoxy group, an unsubstituted or substituted aryl group or an unsubstituted or substituted mono-valent heterocyclic group, particularly preferably an unsubstituted alkyl group. The definitions and examples of the unsubstituted or substituted alkyl group, unsubstituted or substituted alkoxy group, unsubstituted or substituted aryl group, unsubstituted or substituted aryloxy group, unsubstituted or substituted mono-valent heterocyclic group, substituted amino group, substituted silyl group, halogen atom and substituted carboxyl group are the same as described above.

Ar⁵ and Ar⁶ represent preferably an unsubstituted or substituted 1,3-phenylene group, an unsubstituted or substituted 1,4-phenylene group, an unsubstituted or substituted 1,4-naphthalenediyl group, an unsubstituted or substituted 2,6-naphthalenediyl group or an unsubstituted or substituted group represented by the formula (3A-1), more preferably an unsubstituted or substituted 1,4-phenylene group or an unsubstituted or substituted 1,4-naphthalenediyl group, particularly preferably an unsubstituted or substituted 1,4-phenylene group.

Ar⁷ represents preferably an unsubstituted or substituted 1,3-phenylene group, an unsubstituted or substituted 1,4-phenylene group, an unsubstituted or substituted 1,4-naphthalenediyl group, an unsubstituted or substituted 2,7-fluorenediyl group, an unsubstituted or substituted 2,5-pyridinediyl group, an unsubstituted or substituted 1,4-isoquinolinediyl group, an unsubstituted or substituted 4,7-benzo[1,2,5]thiadiazolediyl group, an unsubstituted or substituted 3,7-phenoxazinediyl group or an unsubstituted or substituted group represented by the formula (3A-1), more preferably an unsubstituted or substituted 1,4-phenylene group, an unsubstituted or substituted 2,7-fluorenediyl group or an unsubstituted or substituted group represented by the formula (3A-1), further preferably an unsubstituted or substituted 1,4-phenylene group or an unsubstituted or substituted group represented by the formula (3A-1), particularly preferably an unsubstituted 1,4-phenylene group.

In the formula (3), R³ and R⁴ represent each independently a hydrogen atom, an unsubstituted or substituted alkyl group, an unsubstituted or substituted aryl group or an unsubstituted or substituted mono-valent heterocyclic group. The definitions and examples of these groups and atoms are the same as in the explanation of the substituent which can be carried on Ar¹ and Ar². R³ and R⁴ represent preferably a substituted aryl group or a substituted mono-valent heterocyclic group, more preferably a substituted aryl group.

The repeating unit represented by the formula (3) includes repeating units represented by the following formulae (3B-1) to (3B-4). In these formulae, R^{a} represents a hydrogen atom, an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. A plurality of R^{a}s may be the same or different. The definitions and examples of these groups and atoms are the same as in the explanation of the substituent which can be carried on Ar¹ and Ar².

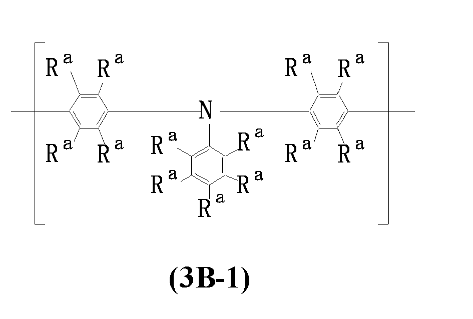

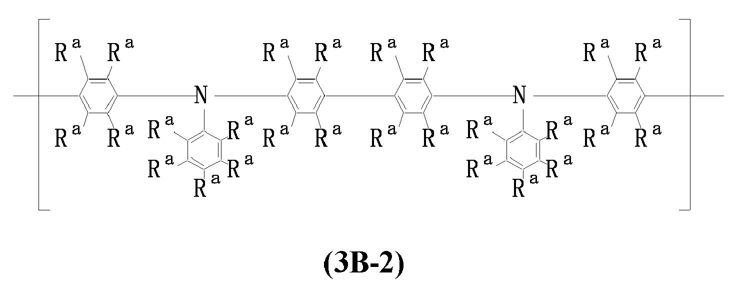

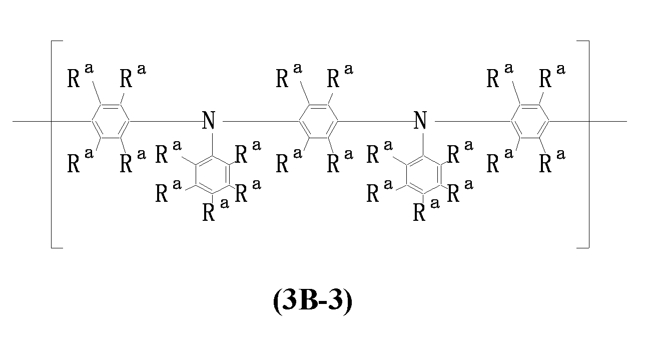

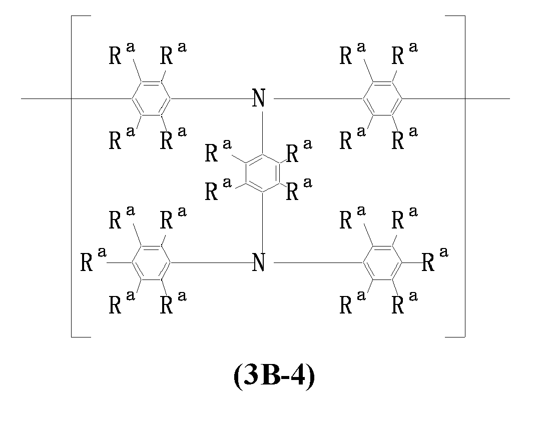

The repeating units represented by the formula (3) may be contained singly or in combination of two or more.

From the standpoint of the luminance half life and the like when the polymer compound is used for fabrication of a light emitting device, the total molar amount of a repeating unit represented by the formula (1), a repeating unit represented by the formula (2) and a repeating unit represented by the formula (3) with respect to the total molar amount of all repeating units, in the polymer compound of the present invention, is preferably 90 to 100%, more preferably 95 to 100%, further preferably 98 to 100%, particularly preferably 100%.

From the standpoint of the light emission efficiency and the like when the polymer compound is used for fabrication of a light emitting device, the total molar amount of a repeating unit represented by the formula (1) with respect to the total molar amount of all repeating units, in the polymer compound of the present invention, is preferably 0.01 to 90%, more preferably 1 to 50%, further preferably 3 to 30%, particularly preferably 5 to 20%.

The polystyrene-equivalent number average molecular weight (Mn) according to gel permeation chromatography (hereinafter, referred to as "GPC") of the polymer compound of the present invention is usually 1×10³ to 1×10⁸, preferably 1×10⁴ to 1×10⁶. The polystyrene-equivalent weight average molecular weight (Mw) of the polymer compound of the present invention is usually 1×10³ to 1×10⁸, and from the standpoint of film formability and the like, is preferably 1×10⁴ to 5×10⁶, more preferably 3×10⁴ to 1×10⁶, further preferably 5×10⁴ to 5×10⁵.

As for the end group of the polymer compound of the present invention, if a polymerization active group remains intact thereon, there is a possibility of decrease in a light emitting property and life when the polymer compound is used for fabrication of a light emitting device, thus, the end group is preferably a stable group. As the end group, those having a conjugated bond to the main chain are preferable, and structures having a bond to an aryl group or a heterocyclic group via a carbon-carbon bond are mentioned (specifically, substituents described in chemical formula 10 in JP-A No. 9-45478, and the like).

The polymer compound of the present invention includes block copolymers, random copolymers, alternating copolymers and graft copolymers.

The polymer compound of the present invention includes the following compounds (P-1) to (P-7). For example, (P-1) is a copolymer constituted of a repeating unit represented the above-described formula (1-1) and a repeating unit represented by the following formula: 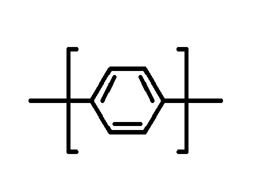 at a molar ratio of Q1:Q2, and the same shall apply to (P-2) to (P-7). Here, R¹, R², R⁵, R⁶, R⁷, R⁸ and R^{a} have the same meaning as described above. Q1 to Q17 are numbers satisfying the following formula.

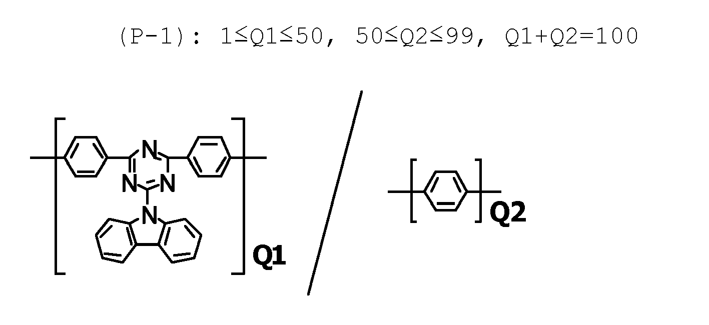

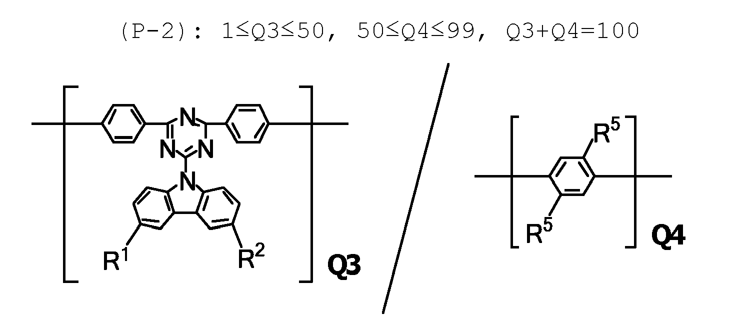

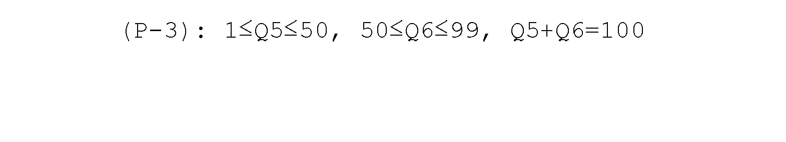

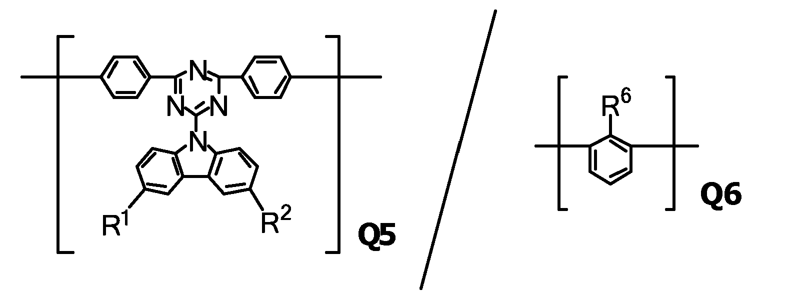

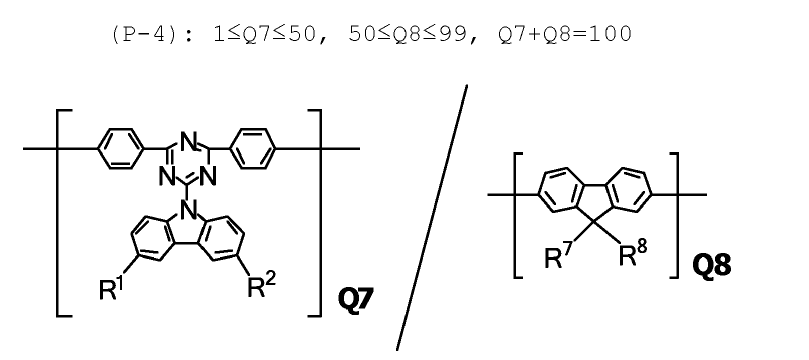

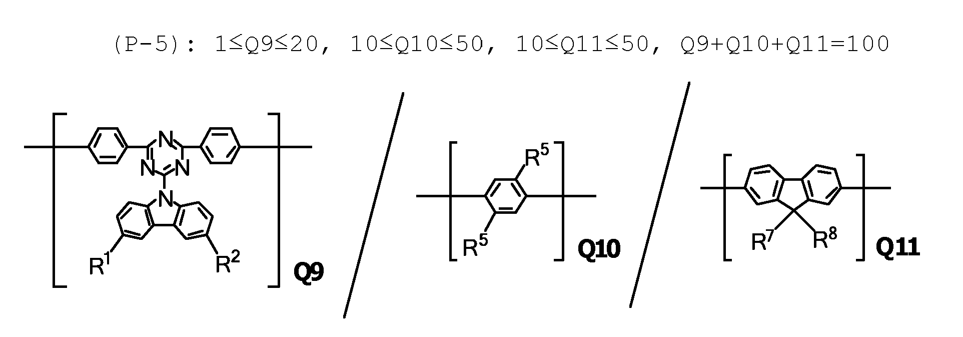

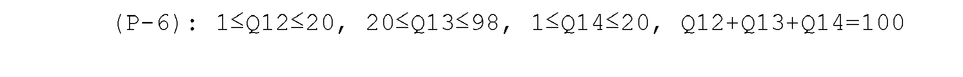

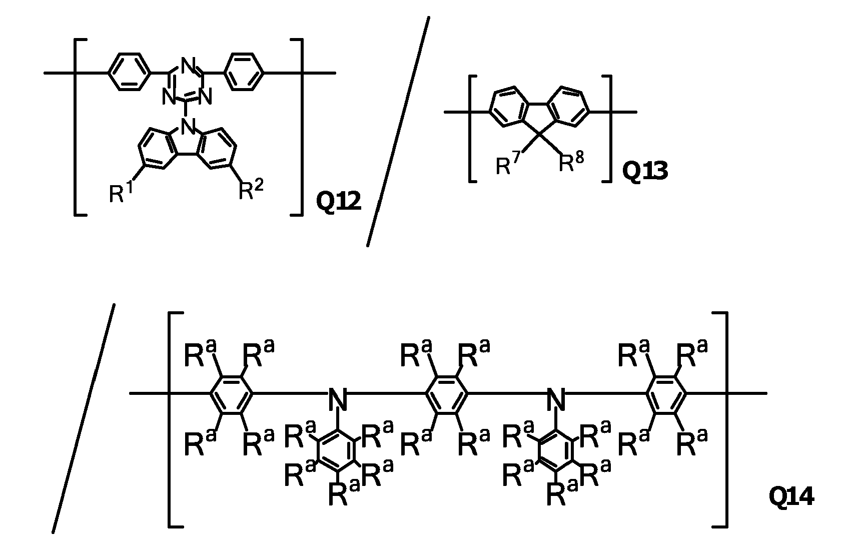

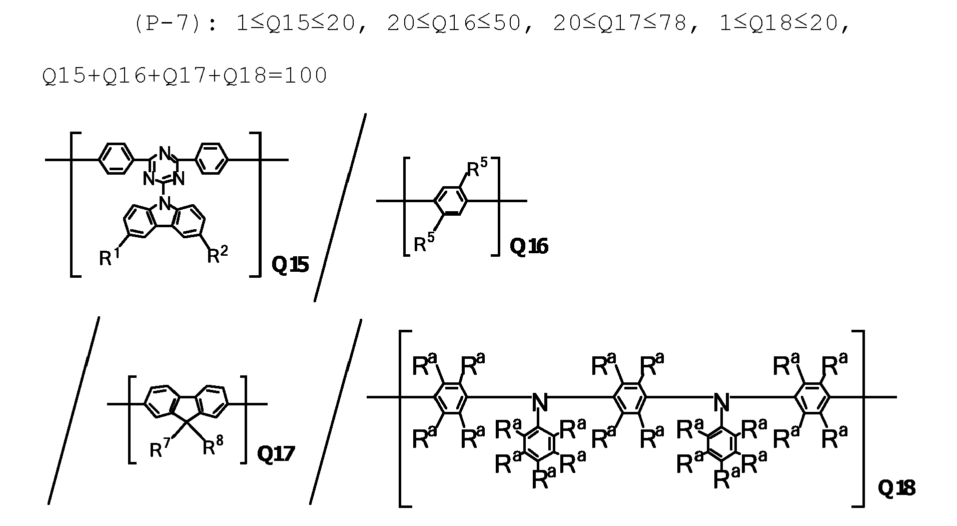

The polymer compound of the present invention is useful as a light emitting material, a charge transporting material or the like.

### <Production method of polymer compound>

Preferable methods of producing the polymer compound of the present invention will be described.

The polymer compound of the present invention can be produced, for example, by condensation polymerization of a compound represented by the formula (a). When the polymer compound of the present invention has a repeating unit represented by the formula (2) and a repeating unit represented by the formula (3), it can be produced, for example, by condensation-polymerizing at least one compound represented by the formula (a) with at least one compound selected from the group consisting of a compound represented by the following formula (b-1) and a compound represented by the following formula (b-2).

Y¹-Ar⁴-Y **(b-1)**

(wherein Ar⁴ and Y¹ have the same meaning as described above.) 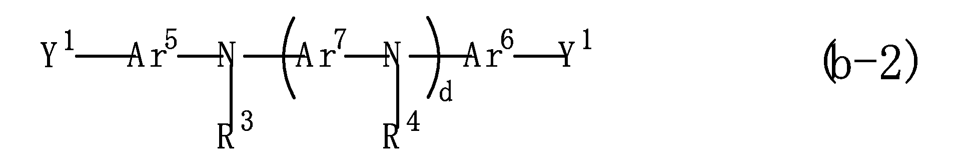 (wherein Ar⁵, Ar⁶, Ar⁷, R³, R⁴, Y¹ and d represents the same meaning as described above.)

The halogen atom represented by Y¹ and X_{A} in the formulae (a), (b-1), (b-2), (a-2) and (a-3) includes a chlorine atom, a bromine atom and an iodine atom.

The borate residue represented by Y¹ in the formulae (a), (b-1) and (b-2) includes groups represented by the following formulae.

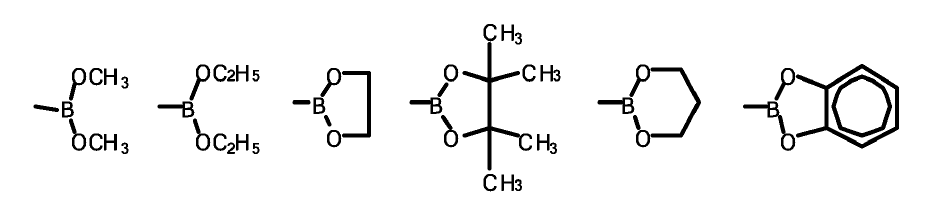

The definitions and examples of the unsubstituted or substituted alkyl group and unsubstituted or substituted aryl group represented by R^{T} in the formula (a-1) are the same as the definitions and examples in the explanation of the substituent which can be carried on Ar¹ and Ar².

The sulfonate group represented by the formula (a-1) includes a methanesulfonate group, trifluoromethanesulfonate group, phenylsulfonate group and 4-methylphenylsulfonate group.

The definitions and examples of the unsubstituted or substituted alkyl group and unsubstituted or substituted aryl group represented by R^{T} in the formula (a-4) are the same as the definitions and examples in the explanation of the substituent which can be carried on Ar¹ and Ar². The group represented by the above-described formula (a-4) includes a trimethylstannanyl group, a triethylstannanyl group and a tributylstannanyl group.

As the compound represented by the formula (a), (b-1) or (b-2), those previously synthesized and isolated may be used, or the compound may be prepared in a reaction system and used as it is.

Y¹ in the formulae (a), (b-1) and (b-2) is preferably a halogen atom, a borate residue or a boric acid residue, more preferably a halogen atom or a borate residue, from the standpoint of simplicity of synthesis and easiness of handling of compounds represented by the formulae (a), (b-1) and (b-2).

The halogen atom represented by Y¹ is preferably a chlorine atom, a bromine atom or an iodine atom, more preferably a bromine atom or an iodine atom, further preferably a bromine atom.

The borate residue represented by Y¹ is preferably a group represented by the following formula (BE-1) or (BE-2), more preferably a group represented by the following formula (BE-2).

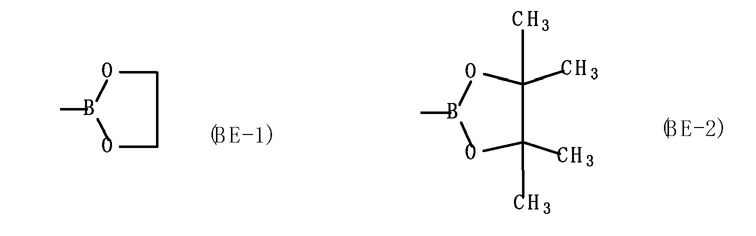

As the compound represented by the formula (a), a compound represented by the formula (a') is preferable (groups represented by R¹' and R²' in the formula (a') are the same as explained and exemplified in the section of R¹ and R²) .

Ar³ in the formula (a') is preferably a single bond.

As the compound represented by the formula (a'), compounds represented by the following formulae are more preferable.

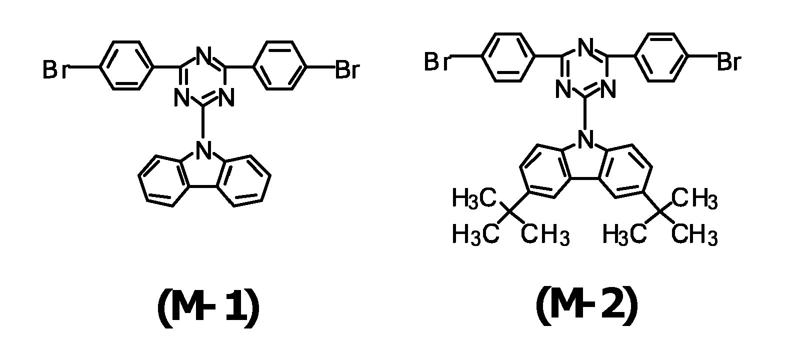

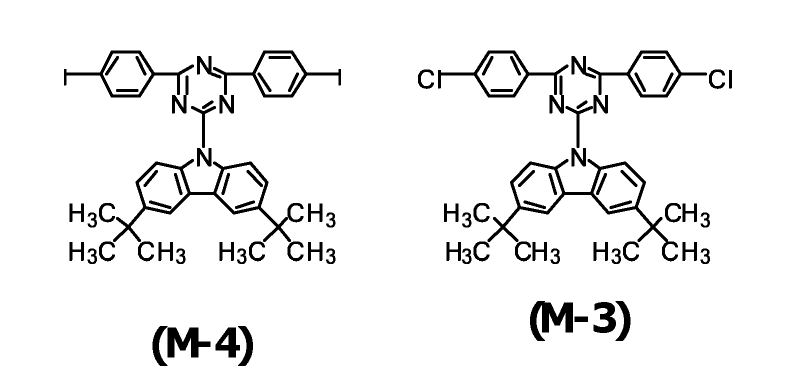

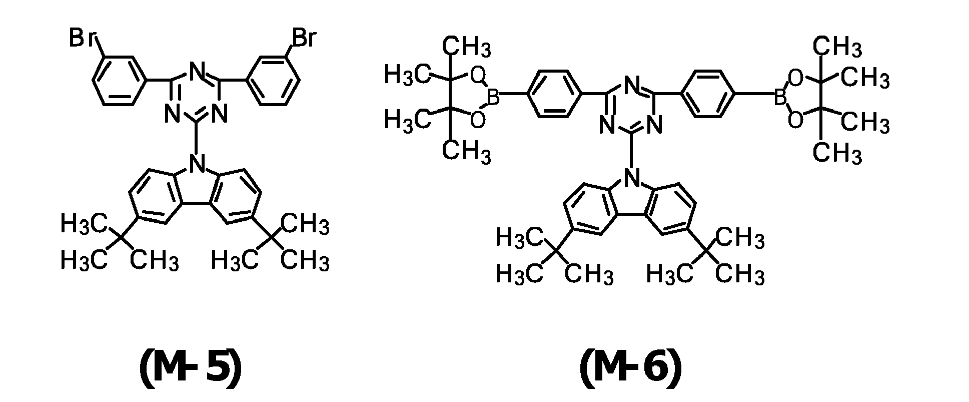

The condensation polymerization method includes methods of reacting compounds represented by the formulae (a), (b-1) and (b-2), if necessary, using a suitable catalyst or a suitable base.

The catalyst includes catalysts composed of a transition metal complex such as a palladium complex such as palladium[tetrakis(triphenylphosphine)], [tris(dibenzylideneacetone)]dipalladium, palladium acetate and the like, a nickel complex such as nickel[tetrakis(triphenylphosphine)], [1,3-bis(diphenylphosphino)propane]dichloronickel, [bis(1,4-cyclooctadiene)]nickel and the like, or other complex, and if necessary, further, a ligand such as triphenylphosphine, tri(t-butylphosphine), tricyclohexylphosphine, diphenylphosphinopropane, bipyridyl and the like. As the catalyst, those previously synthesized may be used, or the catalyst prepared in a reaction system may be used as it is. These catalysts may be used singly or in combination of two or more.

In the case of use of a catalyst, its use amount is preferably 0.00001 to 3 molar equivalents, more preferably 0.00005 to 0.5 molar equivalents, further preferably 0.0001 to 0.2 molar equivalents in terms of the amount of a transition metal with respect to the sum of the molar amounts of compounds represented by the above-described the formulae (a), (b-1) and (b-2).

The base includes inorganic bases such as sodium carbonate, potassium carbonate, cesium carbonate, potassium fluoride, cesium fluoride, tripotassium phosphate and the like, and organic bases such as tetrabutylammonium fluoride, tetrabutylammonium chloride, tetrabutylammonium bromide, tetrabutylammonium hydroxide and the like. These bases may be used singly or in combination of two or more.

In the case of use of a base, its use amount is preferably 0.5 to 20 molar equivalents, more preferably 1 to 10 molar equivalents with respect to the sum of the molar amounts of compounds represented by the above-described the formulae (a), (b-1) and (b-2).

Condensation polymerization is carried out usually in the presence of a solvent (particularly, organic solvent).

The organic solvent varies depending on the reaction and the kind of a compound represented by the above-described the formula (a), (b-1) or (b-2), and examples thereof include toluene, xylene, mesitylene, tetrahydrofuran, 1,4-dioxane, dimethoxyethane, N,N-dimethylacetamide and N,N-dimethylformamide. It is desirable to carry out a deoxidation treatment on these solvents, for suppressing side reactions. These organic solvents may be used singly or in combination of two or more.

The use amount of the organic solvent is so regulated that the total concentration of compounds represented by the above-described formulae (a), (b-1) and (b-2) is usually 0.1 to 90 wt%, preferably 1 to 50 wt%, more preferably 2 to 30 wt%.

The reaction temperature of condensation polymerization is preferably -100 to 200°C, more preferably -80 to 150°C, further preferably 0 to 120°C.

The reaction time is usually 1 hour or more, preferably 2 to 500 hours, though varying depending on conditions such as the reaction temperature and the like.

It is desirable to carry out condensation polymerization under anhydrous conditions in some cases, such as when Y¹ in the above-described formulae (a), (b-1) and (b-2) is a group represented by the above-described formula (a-2), and the like.

The condensation polymerization method includes a method of polymerization by the Suzuki reaction (Chemical Review (Chem. Rev.), vol. 95, p. 2457 (1995)), a method of polymerization by the Grignard reaction (Kyoritsu Publication, Polymer Functional Material Series, vol. 2, Synthesis and Reaction of Polymer (2), p. 432 to 433) and a method of polymerization by the Yamamoto Polymerization Method (Progressive Polymer Science (Prog. Polym. Sci.), vol. 17, p. 1153 to 1205, 1992).

The post treatment of condensation polymerization can be carried out by known methods in which, into a lower alcohol such as methanol and the like, the reaction solution obtained in the above-described condensation polymerization is added to cause deposition of a precipitate which is then filtrated and dried, and the like.

By this post treatment, the polymer compound of the present invention is obtained. When the purity of the polymer compound is low, it may be advantageously purified by usual methods such as recrystallization, continuous extraction by a Soxhlet extractor, column chromatography and the like.

### <Composition>

The composition of the present invention comprises at least one material selected from the group consisting of a hole transporting material, an electron transporting material and a light emitting material, and the polymer compound of the present invention. This composition can be used, for example, as a light emitting material or a charge transporting material.

Examples of the hole transporting material, electron transporting material and light emitting material include hole transporting materials, electron transporting materials and light emitting materials which may be contained in an organic layer of a light emitting device to be described later.

The content ratio of at least one material selected from the group consisting of a hole transporting material, an electron transporting material and a light emitting material to the polymer compound of the present invention may be determined depending on its use, and in the case of light emitting material use, the weight of the polymer compound of the present invention is usually 20 to 99 parts by weight, preferably 40 to 95 parts by weight with respect to 100 parts by weight of the weight of the whole composition.

The composition of the present invention has a polystyrene-equivalent number average molecular weight of usually 1×10³ to 1×10⁸, preferably 1×10⁴ to 1×10⁶. The composition of the present invention has a polystyrene-equivalent weight average molecular weight of usually 1×10³ to 1×10⁸, and from the standpoint of film formability and the light emission efficiency of the resultant device, preferably 1×10⁴ to 5×10⁶. The average molecular weight of the composition of the present invention is a value obtained by analyzing the composition by GPC.

### <Solution>

The composition of the present invention can also be prepared in the form of a solution by allowing a solvent such as an organic solvent or the like to be contained. This solution is called an ink or an ink composition in some cases.

The solution of the present invention is a solution containing the polymer compound of the present invention and a solvent. This solution is useful for fabrication of a device by an application method such as an inkjet print method, a printing method and the like. The solution of the present invention may contain a hole transporting material, an electron transporting material, a light emitting material, a stabilizer, a thickening agent (a high molecular weight compound or a poor solvent for enhancing viscosity), a low molecular weight compound for lowering viscosity, a surfactant (for lowering surface tension), an antioxidant and the like, in addition to the polymer compound of the present invention and the solvent.

The proportion of the polymer compound of the present invention in the solution of the present invention is usually 0.1 to 99.9 parts by weight, preferably 0.1 to 10 parts by weight, more preferably 0.2 to 7 parts by weight, further preferably 0.5 to 2 parts by weight, with respect to 100 parts by weight of the solution.

The viscosity of the solution of the present invention may be adjusted depending on the kind of a printing method, and the viscosity at 25°C is preferably in the range of 1 to 20 mPa•s, for preventing clogging and flying curving in discharging, when the solution passes through a discharge apparatus such as in an inkjet print method and the like.

The high molecular weight compound to be used as the thickening agent may advantageously be an agent which is soluble in the same solvent as for the polymer compound of the present invention and which does not disturb light emission and charge transportation, and use can be made of, for example, high molecular weight polystyrene and high molecular weight polymethyl methacrylate. These high molecular weight compounds have a polystyrene-equivalent weight average molecular weight of preferably 5×10⁵ or more, more preferably 1×10⁶ or more.

It is also possible to use a poor solvent as the thickening agent. By adding a small amount of poor solvent for solid components in the solution, the viscosity can be enhanced. When a poor solvent is added for this purpose, the kind of the solvent and the addition amount thereof may be selected in the range not causing deposition of solid components in the solution. When also stability during preservation is taken into consideration, the amount of the poor solvent is preferably 50 parts by weight or less, further preferably 30 parts by weight or less, with respect to 100 parts by weight of the whole solution.

The antioxidant is an agent for improving the preservation stability of the solution of the present invention. The antioxidant may advantageously be an agent which is soluble in the same solvent as for the polymer compound of the present invention and which does not disturb light emission and charge transportation, and a phenol antioxidant, a phosphorus antioxidant and the like are exemplified.

As the solvent in the solution of the present invention, preferable are those capable of dissolving or uniformly dispersing solid components in the solution. The solvent includes chlorine-based solvents such as chloroform, methylene chloride, 1,2-dichloroethane, 1,1,2-trichloroethane, chlorobenzene, o-dichlorobenzene and the like; ether solvents such as tetrahydrofuran, dioxane, anisole and the like; aromatic hydrocarbon solvents such as toluene, xylene and the like; aliphatic hydrocarbon solvents such as cyclohexane, methylcyclohexane, n-pentane, n-hexane, n-heptane, n-octane, n-nonane, n-decane and the like; ketone solvents such as acetone, methyl ethyl ketone, cyclohexanone, benzophenone, acetophenone and the like; ester solvents such as ethyl acetate, butyl acetate, ethyl cellosolve acetate, methyl benzoate, phenyl acetate and the like; polyhydric alcohols such as ethylene glycol, ethylene glycol monobutyl ether, ethylene glycol monoethyl ether, ethylene glycol monomethyl ether, dimethoxyethane, propyrene glycol, diethoxymethane, triethylene glycol monoethyl ether, glycerin, 1,2-hexane diol and the like, and derivatives thereof; alcohol solvents such as methanol, ethanol, propanol, isopropanol, cyclohexanol and the like; sulfoxide solvents such as dimethyl sulfoxide and the like; amide solvents such as N-methyl-2-pyrrolidone, N,N-dimethylformamide and the like. These solvents may be used singly or in combination of two or more. Of them, preferable are aromatic hydrocarbon solvents, ether solvents, aliphatic hydrocarbon solvents, ester solvents and ketone solvents, more preferable are toluene, xylene, ethylbenzene, diethylbenzene, trimethylbenzene, n-propylbenzene, isopropylbenzene, n-butylbenzene, isobutylbenzene, s-butylbenzene, n-hexylbenzene, cyclohexylbenzene, 1-methylnaphthalene, tetralin, anisole, ethoxybenzene, cyclohexane, bicyclohexyl, cyclohexenylcyclohexanone, n-heptylcyclohexane, n-hexylcyclohexane, decalin, methyl benzoate, cyclohexanone, 2-propylcyclohexanone, 2-heptanone, 3-heptanone, 4-heptanone, 2-octanone, 2-nonanone, 2-decanone, dicyclohexyl ketone, acetophenone and benzophenone, from the standpoint of solubility of the polymer compound of the present invention or the like, uniformity in film formation, viscosity property and the like.

It is preferable to use two or more solvents, it is more preferable to use two to three solvents and it is particularly preferable to use two solvents, from the standpoint of film formability, device property and the like.

When two solvents are contained in the solution of the present invention, one of them may be solid at 25°C. From the standpoint of film formability, it is preferable that one solvent has a boiling point of 180°C or higher, more preferably a boiling point of 200°C or higher. From the standpoint of viscosity, it is preferable that the polymer compound is dissolved at a concentration of 1 wt% or more at 60°C in both two solvents, and it is preferable that the polymer compound is dissolved at a concentration of 1 wt% or more at 25°C in one of the two solvents.

When two or more solvents are contained in the solution of the present invention, the content of a solvent having the highest boiling point is preferably 40 to 90 wt%, more preferably 50 to 90 wt%, and further preferably 65 to 85 wt% with respect to the weight of all solvents contained in the solution, from the standpoint of viscosity and film formability.

One polymer compound or two or more polymer compounds of the present invention may be contained in the solution of the present invention, and other high molecular weight compound than the polymer compound may be contained in the range not deteriorating a device property and the like.

The solution of the present invention may contain water, metals and salts thereof in an amount of 1 to 1000 ppm by weight. The metal includes lithium, sodium, calcium, potassium, iron, copper, nickel, aluminum, zinc, chromium, manganese, cobalt, platinum, iridium and the like. The solution of the present invention may contain silicon, phosphorus, fluorine, chlorine, bromine and the like in an amount of 1 to 1000 ppm by weight.

### <Film>

The film of the present invention contains the polymer compound of the present invention, and for example, is a luminous film, an electric conductive film, an organic semiconductor film or the like.

The film of the present invention can be fabricated by a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet print method, a capillary coat method or a nozzle coat method, preferably by a screen printing method, a flexo printing method, an offset printing method or an inkjet print method, more preferably by an inkjet print method.

When a film is fabricated using the solution of the present invention, it is possible to carry out heating at a temperature of 100°C or higher since the polymer compound of the present invention contained in the solution has high glass transition temperature, and even if heated at a temperature of 130°C, decrease in a device property is usually small. Depending on the kind of the polymer compound, heating at a temperature of 160°C or higher is also possible.

The luminous film has a light emission quantum yield of preferably 30% or more, more preferably 50% or more, further preferably 60% or more, particularly preferably 70% or more, from the standpoint of the luminance, light emission voltage and the like of a device.

The electric conductive film has a surface resistance of preferably 1 KΩ/□ or less, more preferably 100 Ω/□ or less, further preferably 10 Ω/□ or less. By doping the electric conductive film with a Lewis acid, an ionic compound or the like, electric conductivity can be enhanced.

In the organic semiconductor film, one larger parameter of electron mobility or hole mobility is preferably 10⁻⁵ cm²/V/s or more, more preferably 10⁻³ cm²/V/s or more, particularly preferably 10⁻¹ cm²/V/s or more. By forming the organic semiconductor film on a Si substrate carrying a gate electrode and an insulation film made of SiO₂ and the like formed thereon, and forming a source electrode and a drain electrode with Au and the like, an organic transistor can be fabricated.

### <Light emitting device>

The light emitting device of the present invention will be explained.

The light emitting device of the present invention is a light emitting device having electrodes consisting of an anode and a cathode, and an organic layer containing the above-described polymer compound disposed between the electrodes.

The above-described organic layer is preferably at least one layer selected from the group consisting of a light emitting layer, a hole transporting layer, a hole injection layer, an electron transporting layer, an electron injection layer and an interlayer layer, and it is more preferable that the above-described organic layer is a light emitting layer.

The light emitting layer means a layer having a function of light emission. The hole transporting layer means a layer having a function of transporting holes. The electron transporting layer means a layer having a function of transporting electrons. The interlayer layer means a layer which is present adjacent to a light emitting layer between the light emitting layer and an anode, and having a function of insulating a light emitting layer and an anode, or a light emitting layer and a hole injection layer or hole transporting layer. The electron transporting layer and the hole transporting layer are generically called a charge transporting layer. The electro injection layer and the hole injection layer are generically called a charge injection layer. The light emitting layer, the hole transporting layer, the hole injection layer, the electron transporting layer, the electron injection layer and the interlayer layer may each be composed of a single layer or two or more layers.

When the organic layer is a light emitting layer, the light emitting layer may further contain at least one material selected from the group consisting of a hole transporting material, an electron transporting material, a light emitting material, and an additive for elongating the luminance half life of a light emitting device. The light emitting material means a material showing fluorescence and/or phosphorescence (excluding the polymer compound of the present invention).

When the organic layer contains the polymer compound of the present invention and a hole transporting material, the proportion of the hole transporting material with respect to 100 parts by weight of the sum of the polymer compound of the present invention and the hole transporting material is usually 1 to 80 parts by weight, preferably 5 to 60 parts by weight.

When the organic layer contains the polymer compound of the present invention and an electron transporting material, the proportion of the electron transporting material with respect to 100 parts by weight of the sum of the polymer compound of the present invention and the electron transporting material is usually 1 to 80 parts by weight, preferably 5 to 60 parts by weight.

When the organic layer contains the polymer compound of the present invention and a light emitting material, the proportion of the light emitting material with respect to 100 parts by weight of the sum of the polymer compound of the present invention and the light emitting material is usually 1 to 80 parts by weight, preferably 5 to 60 parts by weight.

When the organic layer contains the polymer compound of the present invention and two or more materials selected from the group consisting of a hole transporting material, an electron transporting material and a light emitting material, the proportion of the light emitting material with respect to 100 parts by weight of the sum of them is usually 1 to 50 parts by weight, preferably 5 to 40 parts by weight, and the total proportion of the hole transporting material and the electron transporting material with respect to 100 parts by weight of the sum of them is usually 1 to 50 parts by weight, preferably 5 to 40 parts by weight.

As the hole transporting material, electron transporting material and light emitting material, known low molecular weight compounds, triplet light emitting complexes, and high molecular weight compounds can be used.

The high molecular weight compounds include polymers and copolymers (hereinafter, referred to as "(co)polymer") having a fluorenediyl group as a repeating unit, (co)polymers having an arylene group as a repeating unit, (co)polymers having an arylenevinylene group as a repeating unit, (co)polymers having a di-valent aromatic amine group as a repeating unit, and the like, described in WO99/13692, WO99/48160, GB2340304A, WO00/53656, WO01/19834, WO00/55927, GB2348316, WO00/46321, WO00/06665, WO99/54943, WO99/54385, US5777070, WO98/06773, WO97/05184, WO00/35987, WO00/53655, WO01/34722, WO99/24526, WO00/22027, WO00/22026, WO98/27136, US573636, WO98/21262, US5741921, WO97/09394, WO96/29356, WO96/10617, EP0707020, WO95/07955, JP-A Nos. 2001-181618, 2001-123156, 2001-3045, 2000-351967, 2000-303066, 2000-299189, 2000-252065, 2000-136379, 2000-104057, 2000-80167, 10-324870, 10-114891, 9-111233 and 9-45478.

The low molecular weight compounds include naphthalene derivatives, anthracene and its derivatives, perylene and its derivatives, and polymethine, xanthene, coumarin and cyanine dyes, metal complexes of 8-hydroxyquinoline and its derivatives, aromatic amines, tetraphenylcyclopentadiene and its derivatives, and tetraphenylbutadiene and its derivatives, specifically, those described in JP-A Nos. 57-51781 and 59-194393.

The triplet light emitting complexes include Ir(ppy)₃ and BtP₂Ir(acac) containing iridium as a center metal, ADS066GE marketed from American Dye Source, Inc., PtOEP containing platinum as a center metal, and Eu(TTA)₃phen containing europium as a center metal, and specifically, those described in Nature, (1998), 395, 151, Appl. Phys. Lett. (1999), 75(1), 4, Proc. SPIE-Int. Soc. Opt. Eng. (2001), 4105(Organic Light-Emitting Materials and DevicesIV): 119, J. Am. Chem. Soc., (2001): 123, 4304, Appl. Phys. Lett., (1997), 71(18), 2596, Syn. Met., (1998), 94(1): 103, Syn. Met., (1999), 99(2): 1361, Adv. Mater., (1999): 11(10), 852 , Jpn.J.Appl.Phys.,34, 1883 (1995).

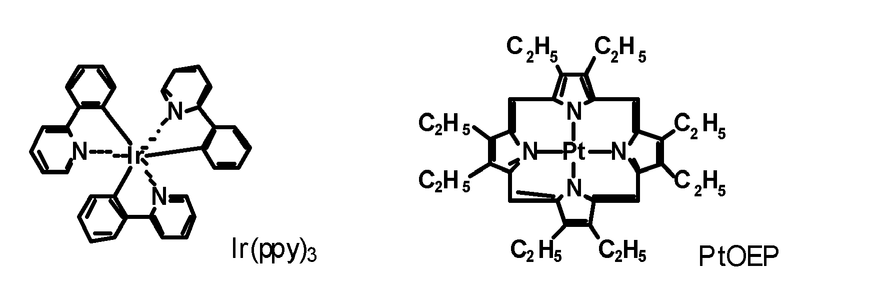

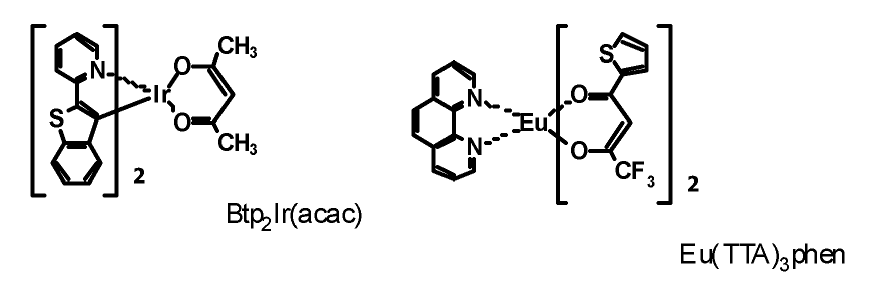

The additive for elongating the luminance half life of a light emitting device includes bipyridyls such as 2,2'-bipyridyl, 3,3'-bipyridyl, 4,4'-bipyridyl and the like, bipyridyl derivatives such as 4-methyl-2,2'-bipyridyl, 5-methyl-2,2'-bipyridyl, 5,5'-dimethyl-2,2'-bipyridyl and the like.

The thickness of the light emitting layer shows an optimum value varying depending on the material to be used, and may advantageously be selected so as to give suitable values of the driving voltage and light emission efficiency, and it is usually 1 nm to 1 µm, preferably 2 nm to 500 nm, more preferably 5 nm to 200 nm, further preferably 50 nm to 150 nm.

The light emitting layer forming method includes methods of film formation from a solution. For film formation from a solution, use can be made of application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet print method, a capillary coat method, a nozzle coat method and the like, and preferable from the standpoint of easiness of pattern formation and multi-color separate painting are printing methods such as a screen printing method, a flexo printing method, an offset printing method, an inkjet print method and the like.

The light emitting device of the present invention includes a light emitting device having an electron transporting layer disposed between a cathode and a light emitting layer, a light emitting device having a hole transporting layer disposed between an anode and a light emitting layer, and a light emitting device having an electron transporting layer disposed between a cathode and a light emitting layer and having a hole transporting layer disposed between an anode and a light emitting layer.

As the structure of such light emitting devices, the following structures a) to d) are exemplified.
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode
(wherein, / means adjacent lamination of layers, the same shall apply hereinafter)

In each of these structures, an interlayer layer may be provided adjacent to a light emitting layer between the light emitting layer and an anode. As the structure of such light emitting devices, the following structures a') to d') are exemplified.
a') anode/interlayer layer/light emitting layer/cathode
b') anode/hole transporting layer/interlayer layer/light emitting layer/cathode
c') anode/interlayer layer/light emitting layer/electron transporting layer/cathode
d') anode/hole transporting layer/interlayer layer/light emitting layer/electron transporting layer/cathode

When the light emitting device of the present invention has a hole transporting layer, the hole transporting layer usually contains the above-described hole transporting material (high molecular weight compound, low molecular weight compound). Exemplified as the hole transporting material are polyvinylcarbazole and its derivatives, polysilane and its derivatives, polysiloxane derivatives having an aromatic amine on its side chain or main chain, pyrazoline derivatives, arylamine derivatives, stilbene derivatives, triphenyldiamine derivatives, polyaniline and its derivatives, polythiophene and its derivatives, polypyrrole and its derivatives, poly(p-phenylenevinylene) and its derivatives, poly(2,5-thienylenevinylene) and its derivatives, and the like, and those described in JP-A Nos. 63-70257, 63-175860, 2-135359, 2-135361, 2-209988, 3-37992 and 3-152184, and the like.

Among them, preferable as the high molecular weight compound are polyvinylcarbazole and its derivatives, polysilane and its derivatives, polysiloxane derivatives having an aromatic amine compound group on its side chain or main chain, polyaniline and its derivatives, polythiophene and its derivatives, poly(p-phenylenevinylene) and its derivatives, poly(2,5-thienylenevinylene) and its derivatives, and the like, and more preferable are polyvinylcarbazole and its derivatives, polsilane and its derivatives, and polysiloxane derivatives having an aromatic amine on its side chain or main chain.

Among them, exemplified as the low molecular weight compound are pyrazoline derivatives, arylamine derivatives, stilbene derivatives, and triphenyldiamine derivatives. It is preferable that these low molecular weight compounds are dispersed in a polymer binder in use.

The polymer binder is preferably one which does not extremely disturb charge transportation, and showing no strong absorption against visible ray. Exemplified as the polymer binder are poly(N-vinylcarbazole), polyaniline and its derivatives, polythiophene and its derivatives, poly(p-phenylenevinylene) and its derivatives, poly(2,5-thienylenevinylene) and its derivatives, polycarbonate, polyacrylate, polymethyl acrylate, polymethyl methacrylate, polystyrene, polyvinyl chloride, polysiloxane and the like.

Polyvinylcarbazole and its derivatives are obtained, for example, from a vinyl monomer by cation polymerization or radical polymerization.

As the polysilane and its derivative, compounds described in Chemical Review (Chem. Rev.), vol. 89, p. 1359 (1989), GB2300196, and the like are exemplified. Also as the synthesis method, methods described in them can be used, and particularly, the Kipping method is suitably used.

In the polysiloxane and its derivative, the siloxane skeleton structure shows little hole transporting property, thus, those having the structure of the above-described low molecular weight hole transporting material on its side chain or main chain are preferable, and those having a hole transportable aromatic amine on its side chain or main chain are more preferable.

As the film formation method of a hole transporting layer, a method of film formation from a mixed solution with a polymer binder is exemplified in the case of use of a low molecular weight compound, and a method of film formation from a solution is exemplified in the case of use of a high molecular weight compound.

As the solvent used for film formation from a solution, those which can dissolve or uniformly disperse a hole transporting material are preferable. Exemplified as the solvent are chlorine-based solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethylcellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide and the like. These organic solvents may be used singly or in combination of two or more.

For film formation from a solution, there can be used application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method and the like.

The thickness of a hole transporting layer shows an optimum value varying depending on the material to be used, and it may be advantageously selected so as to give suitable values of the driving voltage and light emission efficiency, and a thickness at least causing no formation of pin holes is necessary, and when the thickness is too large, the driving voltage of a device increases undesirably. Therefore, the thickness of the hole transporting layer is usually 1 nm to 1 pm, preferably 2 nm to 500 nm, more preferably 5 nm to 200 nm.

When the light emitting device of the present invention has an electron transporting layer, the electron transporting layer usually contains the above-described electron transporting material (high molecular weight compound, low molecular weight compound). As the electron transporting material, known materials can be used, and exemplified are oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and the like, and those described in JP-A Nos. 63-70257, 63-175860, 2-135359, 2-135361, 2-209988, 3-37992 and 3-152184. Of them, preferable are oxadiazole derivatives, benzoquinone and its derivatives, anthraquinone and its derivatives, metal complexes of 8-hydroxyquinoline and its derivatives polyquinoline and its derivatives, polyquinoxaline and its derivatives and polyfluorene and its derivatives, further preferable are 2-(4-biphenylyl)-5-(4-t-butylphenyl)-1,3,4-oxadiazole, benzouqinone, anthraquinone, tris(8-quinolinol)aluminum and polyquinoline.

As the film formation method of an electron transporting layer, exemplified is a vacuum vapor-deposition method from a powder, or a film formation method from a solution or melted condition in the case of use of a low molecular weight compound, and exemplified is a film formation method from a solution or melted condition in the case of use of a high molecular weight compound. In the film formation method from a solution or melted condition, the above-described polymer binder may be used together.

As the solvent used in film formation from a solution, compounds which can dissolve or uniformly disperse an electron transporting material and/or a polymer binder are preferable. Exemplified as the solvent are chlorine-based solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethylcellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide and the like. These solvents may be used singly or in combination of two or more.

For film formation from a solution or melted condition, use can be made of application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet print method, a capillary coat method, a nozzle coat method and the like.

The thickness of an electron transporting layer shows an optimum value varying depending on the material to be used, and it may be advantageously selected so as to give suitable values of the driving voltage and light emission efficiency, and a thickness at least causing no formation of pin holes is necessary, and when the thickness is too large, the driving voltage of a device increases undesirably. Therefore, the thickness of the electron transporting layer is usually 1 nm to 1 pm, preferably 2 nm to 500 nm, more preferably 5 nm to 200 nm.

The hole injection layer and the electron injection layer are charge transporting layers disposed adjacent to an electrode, having a function of improving charge injection efficiency from an electrode and having an effect of lowering the driving voltage of a device.

For improving close adherence to an electrode or improving charge injection from an electrode, the above-described charge injection layer or insulation layer (usually having an average thickness of 0.5 to 4.0 mm, the same shall apply hereinafter) may be disposed adjacent to an electrode, and for improving close adherence of an interface or preventing mixing, a thin buffer layer may be inserted into an interface of a charge transporting layer and a light emitting layer.

The order and number of layers to be laminated, and thickness of each layer may be adjusted in view of light emission efficiency and device life.

In the present invention, the light emitting device having a charge injection layer (electron injection layer, hole injection layer) includes a light emitting device having a charge injection layer disposed adjacent to a cathode and a light emitting device having a charge injection layer disposed adjacent to an anode. The structure of such light emitting devices includes the following structures e) to p).
e) anode/charge injection layer/light emitting layer/cathode
f) anode/light emitting layer/charge injection layer/cathode
g) anode/charge injection layer/light emitting layer/charge injection layer/cathode
h) anode/charge injection layer/hole transporting layer/light emitting layer/cathode
i) anode/hole transporting layer/light emitting layer/charge injection layer/cathode
j) anode/charge injection layer/hole transporting layer/light emitting layer/charge injection layer/cathode
k) anode/charge injection layer/light emitting layer/electron transporting layer/cathode
l) anode/light emitting layer/electron transporting layer/charge injection layer/cathode
m) anode/charge injection layer/light emitting layer/electron transporting layer/charge injection layer/cathode
n) anode/charge injection layer/hole transporting layer/light emitting layer/electron transporting layer/cathode
o) anode/hole transporting layer/light emitting layer/electron transporting layer/charge injection layer/cathode
p) anode/charge injection layer/hole transporting layer/light emitting layer/electron transporting layer/charge injection layer/cathode

Also exemplified are structures having an interlayer layer disposed adjacent to a light emitting layer between the light emitting layer and an anode in each of the above-described structures. In this case, the interlayer layer may function also as a hole injection layer and/or a hole transporting layer.

The charge injection layer includes a layer containing an electric conductive polymer, a layer disposed between an anode and a hole transporting layer and containing a material having ionization potential of a value between an anode material and a hole transporting material contained in a hole transporting layer, a layer disposed between a cathode and an electron transporting layer and containing a material having electron affinity of a value between a cathode material and an electron transporting material contained in an electron transporting layer, and the like.

When the above-described charge injection layer contains an electric conductive polymer, the electric conductivity of the electric conductive polymer is preferably 1×10⁻⁵ to 1×10³ S/cm, and for decreasing leak current between light emission picture elements, more preferably 1×10⁻⁵ to 1×10² S/cm, further preferably 1×10⁻⁵ to 1×10¹ S/cm.

When the charge injection layer contains an electric conductive polymer, the electric conductivity of the electric conductive polymer is preferably 1×10⁻⁵ to 1×10³ S/cm, and for decreasing leak current between light emission picture elements, more preferably 1×10⁻⁵ to 1×10² S/cm, further preferably 1×10⁻⁵ to 1×10¹ S/cm. Usually, for regulating the electric conductivity of the electric conductive polymer in such a range, the electric conductive polymer is doped with a suitable amount of electrons.

As the kind of ions to be doped, an anion is used in a hole injection layer and a cation is used in an electron injection layer. Examples of the anion include a polystyrenesulfonic ion, an alkylbenzenesulfonic ion, a camphorsulfonic ion and the like, and examples of the cation include a lithium ion, a sodium ion, a potassium ion, a tetrabutylammonium ion and the like.

The material used in the charge injection layer may be appropriately selected depending on a relation with the materials of an electrode and an adjacent layer, and exemplified are polyaniline and its derivatives, polythiophene and its derivatives, polypyrrole and its derivatives, polyphenylenevinylene and its derivatives, polythienylenevinylene and its derivatives, polyquinoline and its derivatives, polyquinoxaline and its derivatives, electric conductive polymers such as polymers containing an aromatic amine structure on its main chain or side chain, metal phthalocyanines (copper phthalocyanine and the like), carbon and the like.

As the material of the insulation layer, metal fluorides, metal oxides, organic insulating materials and the like are listed. The light emitting device having the insulation layer includes a light emitting device having an insulation layer disposed adjacent to a cathode and a light emitting device having an insulation layer disposed adjacent to an anode.

The structure of such light emitting devices includes the following structures q) to ab).
q) anode/insulation layer/light emitting layer/cathode
r) anode/light emitting layer/insulation layer/cathode
s) anode/insulation layer/light emitting layer/insulation layer/cathode
t) anode/insulation layer/hole injection layer/light emitting layer/cathode
u) anode/hole injection layer/light emitting layer/insulation layer/cathode
v) anode/insulation layer/hole transporting layer/light emitting layer/insulation layer/cathode
w) anode/insulation layer/light emitting layer/electron transporting layer/cathode
x) anode/light emitting layer/electron transporting layer/insulation layer/cathode
y) anode/insulation layer/light emitting layer/electron transporting layer/insulation layer/cathode
z) anode/insulation layer/hole transporting layer/light emitting layer/electron transporting layer/cathode
aa) anode/hole transporting layer/light emitting layer/electron transporting layer/insulation layer/cathode
ab) anode/insulation layer/hole transporting layer/light emitting layer/electron transporting layer/insulation layer/cathode

Also exemplified are structures having an interlayer layer disposed adjacent to a light emitting layer between the light emitting layer and an anode in each of the above-described structures. In this case, the interlayer layer may function also as a hole injection layer and/or a hole transporting layer.

In structures in which an interlayer layer is applied to the above-described structures a) to ab), it is preferable that the interlayer layer is disposed between an anode and a light emitting layer and constituted of a material having intermediate ionization potential between the anode or hole injection layer or hole transporting layer, and a polymer compound constituting the light emitting layer.

As the material to be used in the interlayer layer, exemplified are polymers containing an aromatic amine such as polyvinylcarbazole and its derivatives, polyarylene derivatives having an aromatic amine on its side chain or main chain, arylamine derivatives, triphenyldiamine derivatives and the like.

The method of film formation of the interlayer layer includes a method of film formation from a solution in the case of use of a high molecular weight material.

As the solvent used in film formation from a solution, compounds which can dissolve or uniformly disperse the material used in the interlayer layer are preferable. Exemplified as the solvent are chlorine-based solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethylcellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide and the like. These solvents may be used singly or in combination of two or more.

For film formation from a solution, use can be made of application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet print method, a capillary coat method, a nozzle coat method and the like.

The thickness of the interlayer layer shows an optimum value varying depending on the material to be used, and may advantageously be selected so as to give suitable values of the driving voltage and light emission efficiency, and it is usually 1 nm to 1 pm, preferably 2 nm to 500 nm, more preferably 5 nm to 200 nm.

When the interlayer layer is disposed adjacent to a light emitting layer, particularly when both the layers are formed by an application method, the two layers are mixed to exert an undesirable influence on the device property of a device and the like in some cases. When the interlayer layer is formed by an application method before formation of a light emitting layer by an application method, there is mentioned a method in which an interlayer layer is formed by an application method, then, the interlayer layer is heated to be insolubilized in an organic solvent to be used for fabrication of a light emitting layer, then, the light emitting layer is formed, as a method for reducing mixing of the materials of the two layers. The above-described heating temperature is usually 150°C to 300°C. The above-described heating time is usually 1 minute to 1 hour. In this case, for removal of components not insolubilized in a solvent by heating, the interlayer layer may advantageously be rinsed with a solvent to be used for formation of a light emitting layer, after heating and before formation of the light emitting layer. When insolubilization in a solvent by heating is carried out sufficiently, the rinsing can be omitted. For insolubilization in a solvent by heating to be carried out sufficiently, it is preferable to use a compound containing polymerizable groups in the molecule, as a high molecular weight compound to be used in an interlayer layer. Further, the number of the polymerizable groups is preferably 5% or more with respect to the number of constituent units in the molecule.

The substrate which forms the light emitting device of the present invention may advantageously be one which does not change in forming an electrode and forming a layer of an organic substance, and exemplified are substrates made of a material such as glass, plastic, polymer film, silicon and the like. In the case of an opaque substrate, it is preferable that the opposite electrode is transparent or semi-transparent.

Usually, at least one of an anode and a cathode in the light emitting device of the present invention is transparent or semi-transparent.

As the material of the cathode, an electric conductive metal oxide film, a semi-transparent metal film and the like are listed, and specifically, used is made of films (NESA and the like) formed by using electric conductive compounds such as indium oxide, zinc oxide, tin oxide, and composite thereof: indium-tin-oxide (ITO), indium-zinc-oxide and the like, gold, platinum, silver, copper and the like, and preferable are ITO, indium•zinc•oxide, and tin oxide. As the manufacturing method, a vacuum vapor-deposition method, a sputtering method, an ion plating method, a plating method and the like are mentioned. As the anode, organic transparent electric conductive films made of polyaniline or its derivative, polythiophene or its derivative, and the like may be used. The anode may take a lamination structure consisting of two or more layers.

The thickness of the anode can be appropriately selected in view of light transmission and electric conductivity, and it is, for example, 10 nm to 10 pm, preferably 20 nm to 1 pm, more preferably 50 nm to 500 nm.

For making charge injection easy, a layer made of a phthalocyanine derivative, an electric conductive polymer, carbon and the like; an insulation layer made of a metal oxide, a metal fluoride, an organic insulation material and the like, may be provided on the anode.

As the material of the cathode, materials of small work function are preferable, and used is made of metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys composed of two or more of them, or alloys composed of at least one of them and at least one of gold, silver, platinum, copper, manganese, titanium, cobalt, nickel, tungsten and tin, and graphite and graphite interlaminar compounds, and the like. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy and the like. The cathode may take a laminated structure consisting of two or more layers.

The thickness of the cathode may be appropriately adjusted in view of electric conductivity and durability, and it is usually 10 nm to 10 pm, preferably 20 nm to 1 µm, more preferably 50 nm to 500 nm.

As the cathode fabrication method, a vacuum vapor-deposition method, a sputtering method, a lamination method of thermally press-fitting a metal film, and the like are used. A layer made of an electric conductive polymer, or a layer having an average thickness of 2 nm or less made of a metal oxide, a metal fluoride, an organic insulation material or the like, may be disposed between a cathode and an organic layer (any layer containing the polymer compound of the present invention), and after fabrication of the cathode, a protective layer for protecting the light emitting device may be installed. For use of the light emitting device stably for a long period of time, it is preferable to install a protective layer and/or a protective cover, for protecting the device from outside.

As the protective layer, a high molecular weight compound, a metal oxide, a metal fluoride, a metal boride and the like can be used. As the protective cover, a metal plate, a glass plate, and a plastic plate having a surface which has been subjected to a low water permeation treatment, and the like can be used, and a method of pasting the protective cover to a device substrate with a thermosetting resin or photo-curable resin to attain sealing is suitably used. When a space is kept using a spacer, blemishing of a device can be prevented. If an inert gas such as nitrogen, argon and the like is filled in this space, oxidation of the cathode can be prevented, further, by placing a drying agent such as barium oxide and the like in this space, it becomes easy to suppress moisture adsorbed in a production process or a trace amount of water invading through a hardened resin from imparting damage to the device. It is preferable to adopt at least one strategy among these methods.

The light emitting device of the present invention can be used as a planar light source, a segment display, a dot matrix display, backlight of a liquid crystal display, and the like.

For obtaining planar light emission using the light emitting device of the present invention, it may be advantageous to place a planar anode and a planar cathode so as to overlap. For obtaining light emission in the form of pattern, there are a method in which a mask having a window in the form of pattern is placed on the surface of the above-mentioned planar light emitting diode, a method in which a layer to be a non-light emitting part is formed with extremely large thickness to give substantially no light emission, a method in which either anode or cathode, or both electrodes are formed in the form pattern. By forming a pattern by any of these methods, and placing several electrodes so that on/off is independently possible, a display of segment type is obtained which can display digits, letters, simple marks and the like. Further, for providing a dot matrix device, it may be permissible that both an anode and a cathode are formed in the form of stripe, and placed so as to cross. By using a method in which several polymer fluorescent bodies showing different emission colors are painted separately or a method in which a color filter or a fluorescence conversion filter is used, partial color display and multi-color display are made possible. In the case of a dot matrix device, passive driving is possible, and active driving may also be carried out in combination with TFT and the like. These display devices can be used as a display of a computer, a television, a portable terminal, a cellular telephone, a car navigation, a view finder of video camera, and the like.

Further, the above-mentioned planar light emitting device is of self emitting and thin type, and can be suitably used as a planar light source for back light of a liquid crystal display, or as a planar light source for illumination. If a flexible substrate is used, it can also be used as a curved light source or display.

### EXAMPLES

The present invention will be illustrated in detail by examples below.

In examples, the polystyrene-equivalent number average molecular weight and weight average molecular weight were measured by gel permeation chromatography (GPC, manufactured by Shimadzu Corp., trade name: LC-10Avp). A polymer to be measured was dissolved in tetrahydrofuran so as to give a concentration of about 0.5 wt%, and the solution was injected in an amount of 30 µL into GPC. Tetrahydrofuran was used as the mobile phase of GPC, and allowed to flow at a flow rate of 0.6 mL/min. As the column, two TSKgel Super HM-H (manufactured by Tosoh Corp.) and one TSKgel Super H2000 (manufactured by Tosoh Corp.) were connected serially. A differential refractive index detector (manufactured by Shimadzu Corp., trade name: RID-10A) was used as a detector.

### <Example 1>

### (Synthesis of compound 1)

Under an inert atmosphere, into a three-necked flask was added carbazole (30.01 g, 0.179 mol), zinc chloride (ZnCl₂, 73.61 g, 0.540 mol) and nitromethane (500 g). Then, into this was dropped t-butyl chloride (50.11 g, 0.541 mol) at 20 to 22°C over a period of 70 minutes, and the mixture was stirred at the same temperature for 6 hours. Then, water (200 mL) was added and the mixture was stirred, then, nitromethane was distilled off under reduced pressure. Then, chloroform (500 mL) was added and the mixture was stirred, allowed to stand still to cause liquid separation giving an aqueous layer which was then removed. Then, water (300 mL) was added and the mixture was stirred, allowed to stand still to cause liquid separation giving an aqueous layer which was then removed. This series of operations were carried out twice, the resultant oil layer was concentrated under reduced pressure, to obtain brown solid. The brown solid was recrystallized from chloroform, then, recrystallized from hexane, to obtain a compound 1 represented by the following formula (20.9 g, yield 42%, HPLC area percentage value 98.80). 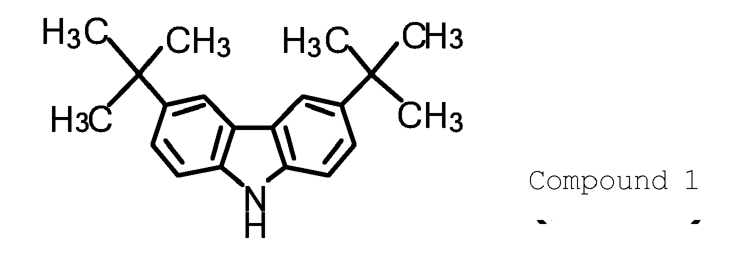 ¹H-NMR (299.4 MHz, CDCl₃): 1.45 (s, 18H), 7.30 (d, 2H), 7.45 (d, 2H), 7.77 (s, 1H), 8.07 (s, 2H)

### (Synthesis of compound 3)

Under an inert atmosphere, into a three-necked flask was added the compound 1 (10.15 g, 35.3 mmol) and tetrahydrofuran (189 mL) to prepare a solution, and into this was dropped n-butyllithium (1.6M hexane solution, 23.8 mL) at 0 to 5°C over a period of 30 minutes, further, the mixture was stirred at the same temperature for 25 minutes to prepared a mixture A.

Then, into a mixture composed of 2,4-bis(4-bromophenyl)-6-chloro-[1,3,5, ]triazine (compound 2, 15.00 g, 35.3 mmol) represented by the following formula: 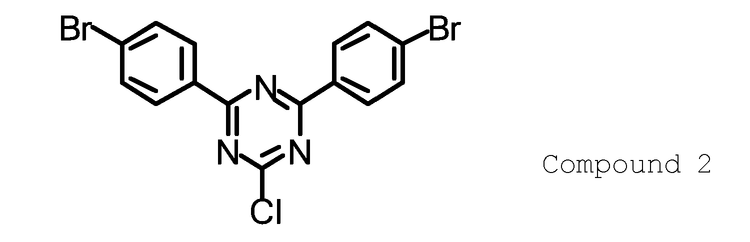 and tetrahydrofuran (150 mL), the above-described mixture A was dropped at 0 to 5°C over a period of 50 minutes, and the mixture was stirred at 25°C for 3 hours. Then, water (14 g) was added at 25°C and the mixture was stirred for 20 minutes, and tetrahydrofuran was distilled off under reduced pressure. Then, chloroform (590 mL) and water (590 mL) were added and the mixture was stirred, then, allowed to stand still to cause liquid separation giving an aqueous layer which was then removed. This series of operations were carried out twice, the resultant oil layer was concentrated under reduced pressure, to obtain pale brown solid. The solid was recrystallized from methanol three times, then, recrystallized from tetrahydrofuran and methanol twice, to obtain a compound 3 represented by the following formula (14.38 g, yield 61%, HPLC area percentage value 99.80). 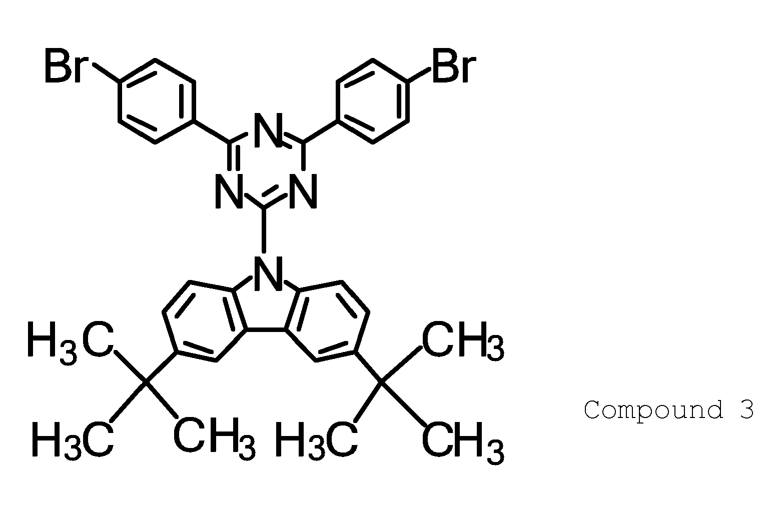 LC-MS (APCI-MS (posi)): 669 [M+H]⁺
¹H-NMR (299.4 MHz, CDCl₃): 1.52 (s, 18H), 7.55 (m, 6H), 7.99 (s, 2H), 8.33 (d, 4H), 8.85 (d, 2H)

### <Example 2>

### (Synthesis of compound 8)

Into a 1-liter three-necked flask was added 2-methyl-2-hexanol (69.49 g, 598.1 mmol), carbazole (50.00 g, 299.0 mmol) and trifluoroacetic acid (300 mL), and the mixture was stirred at 90°C for 21.5 hours. The reaction liquid was cooled to about 25°C, and to this was added diethyl ether(300 mL) and a 3M sodium hydroxide aqueous solution (1.3 L), and the mixture was stirred. Then, to this was added diethyl ether(300 mL) and water (600 mL) and the mixture was stirred, allowed to stand still to cause liquid separation giving an aqueous layer which was then removed. To the resultant oil layer was added water (600 mL) and the mixture was stirred, allowed to stand still to cause liquid separation giving an aqueous layer which was then removed, and the resultant oil layer was concentrated under reduced pressure, to obtain brown liquid. The liquid was subjected to silica gel column chromatography using hexane as a developing solvent, to obtain a compound 8 represented by the following formula (13.05 g, yield 7%). 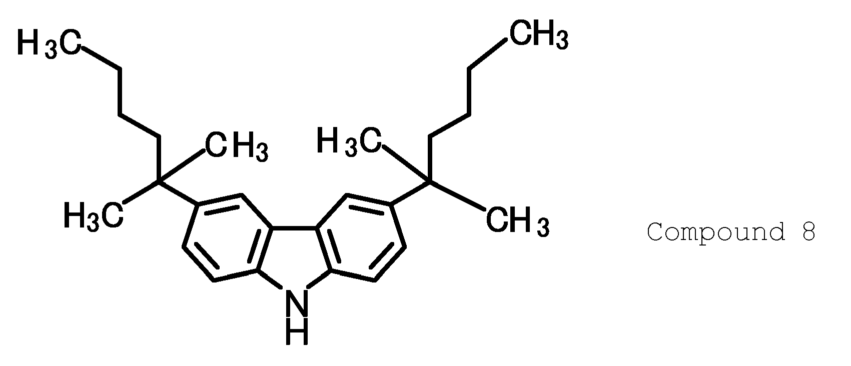 LC-MS (APCI-MS (posi)): 364 [M+H]⁺

### (Synthesis of compound 9)

Under an inert atmosphere, into a three-necked flask was added a compound 8 (3.82 g, 10.5 mmol) and tetrahydrofuran (59 mL) to prepare a solution, into this was dropped n-butyllithium (1.6M hexane solution, 10 mL) at 0 to 5°C over a period of 10 minutes, further, the mixture was stirred at the same temperature for 10 minutes to prepare a mixture B.

Then, into a mixture composed of the compound 2 (4.69 g, 11.0 mmol) and tetrahydrofuran (47 mL), the above-described mixture B was dropped at 0 to 5°C over a period of 25 minutes, and the mixture was stirred at 25°C for 3 hours. Then, water (6 g) was added at 25°C and the mixture was stirred for 1 hour, and toluene (175 mL) and water (100 mL) were added and the mixture was stirred, allowed to stand still to cause liquid separation giving an aqueous layer which was then removed. The resultant oil layer was concentrated under reduced pressure, to obtain pale yellow solid. The solid was subjected to silica gel column chromatography using toluene and haxane as a developing solvent, to obtain pale yellow solid. The solid was recrystallized from toluene, further, recrystallized from toluene and methanol, to obtain a compound 9 represented by the following formula (1.7 g, yield 20.5%). 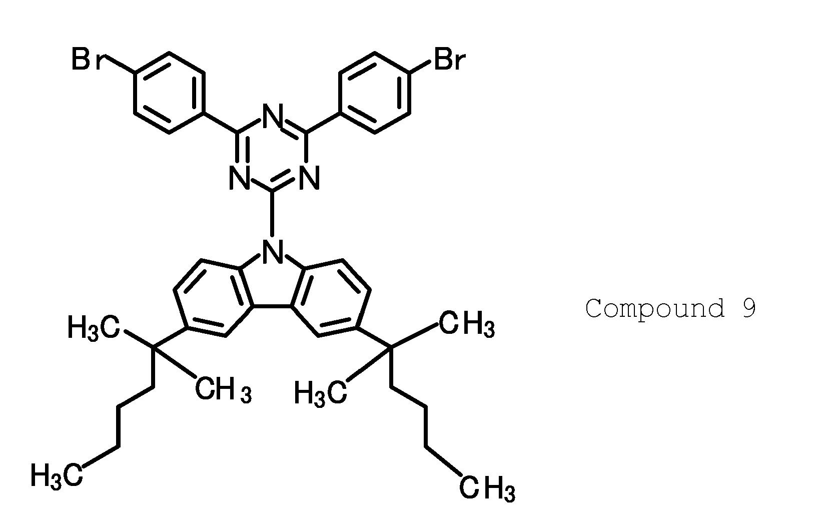 LC-MS (APCI-MS (posi)): 751 [M+H]⁺
¹H-NMR (299.4 MHz, CDCl₃) 9.11 (s, 2H), 8.66 (d, 4H), 7.94 (d, 2H), 7.71 1 (d, 4H), 7.42 (d, 2H): 1.78 - 7.73 (m, 4H): 1.49 (s, 12H): 1.28-1.16 (m, 4H): 1.14-1.04 (m, 4H), 0.79 (d, 6H)

### <Example 3>

### (Synthesis of compound 10)

Under an inert atmosphere, 3,6-dibromocarbazole (7.96 g, 18.7 mmol), 2-(4-hexylphenyl)-4,4,5,5-tetramethyl-1,3,2-dioxaborolane (18.67 g, 47.6 mmol), tetrakis(triphenylphosphine)palladium (1.08 g, 0.9 mmol), 1,4-dioxane (96 mL), potassium carbonate (8.53 g, 61.7 mmol) and water (37 g) were stirred at 105°C for 6 hours. The reaction liquid was cooled to 25°C, then, to this was added diethyl ether (250 mL) and the mixture was stirred, allowed to stand still to cause liquid separation giving an aqueous layer which was then removed. To the resultant oil layer was added water (450 mL) and the mixture was stirred, allowed to stand still to cause liquid separation giving an aqueous layer which was then removed. This series of operations were repeated three times, and the resultant oil layer was concentrated under reduced pressure, to obtain brown solid. The solid was subjected to silica gel column chromatography using hexane and toluene as a developing solvent, to obtain a compound 10 represented by the following formula (5.28 g, yield 43%) . 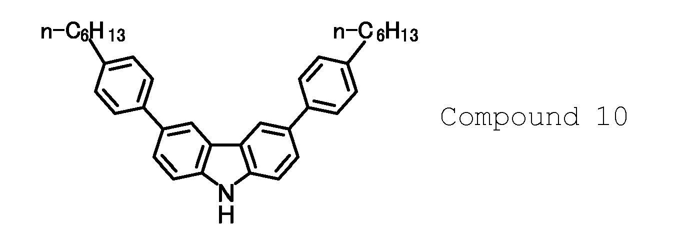 LC-MS (APCI-MS (posi)): 488 [M+H]⁺

### (Synthesis of compound 11)

Under an inert atmosphere, into a three-necked flask was added the compound 10 (4.76 g, 9.8 mmol) and tetrahydrofuran (49 mL) to prepare a solution, into this was dropped n-butyllithium (1.66M hexane solution, 7.36 mL) at 0 to 5°C over a period of 17 minutes, further, the mixture was stirred at the same temperature for 15 minutes to prepare a mixture C.

Then, into a mixture composed of the compound 2 (3.84 g, 9.0 mmol) and tetrahydrofuran (78 mL), the above-described mixture C was dropped at 0 to 5°C over a period of 1 hour, and the mixture was stirred at 25°C for 1 hour. Then, to this was added water (5 g) at 25°C and the mixture was stirred for 1 hour, chloroform and water were added and the mixture was stirred, allowed to stand still to cause liquid separation giving an aqueous layer which was then removed. The resultant oil layer was concentrated under reduced pressure to obtain pale yellow solid. The solid was recrystallized from tetrahydrofuran and methanol twice, and recrystallized from toluene and hexane once, to obtain a compound represented by the following formula (1.60 g, yield 20%). 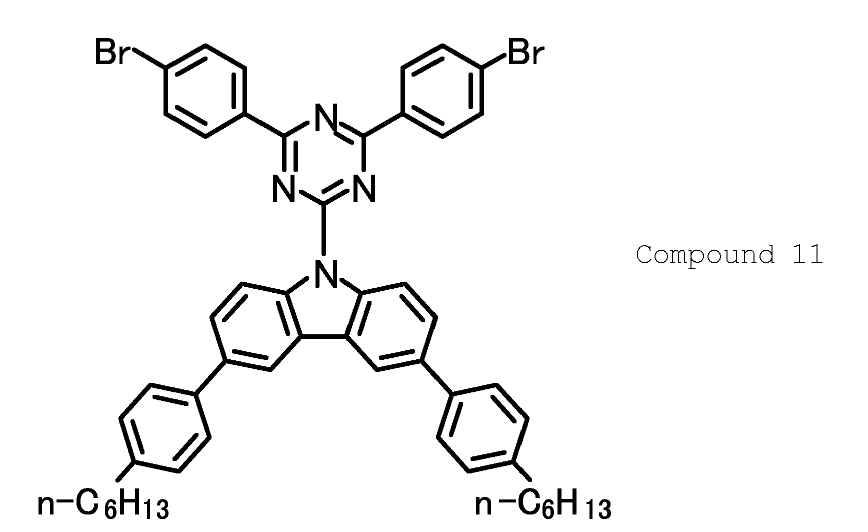 LC-MS (APCI-MS (posi)): 875 [M+H]⁺

### <Example 4>

### (Synthesis of compound 12)

Under an inert atmosphere, into a solution composed of 3,5-dihexyl-bromobenzene (38.00 g, 116.8 mmol) and tetrahydrofuran (441 g), n-butyllithium (1.6M hexane solution, 87.6 mL) was dropped at -76 to -75°C over a period of 1 hour, further, the mixture was stirred at the same temperature for 1 hour. Then, to this was added 2-isopropoxy-4,4,5,5-tetramethyl-1,3,2-dioxaborolane (26.08 g, 140.2 mmol) at -73 to -75°C over a period of 1 hour, and the mixture was stirred at the same temperature for 1 hour. Then, to this was added a saturated ammonium chloride aqueous solution (380 g) at 25°C and the mixture was stirred, and concentrated under reduced pressure to remove the solvent. Then, to the resultant mixture was added hexane and the mixture was stirred, allowed to stand still to cause liquid separation giving an aqueous layer which was then removed. To the resultant oil layer was added anhydrous sodium carbonate and the mixture was stirred, and the resultant mixture was passed through a filter matted with silica gel, a filter matted with activated carbon and a filter matted with celite in this order, and the resultant solution was concentrated under reduced pressure, to obtain a compound 12 represented by the following formula (44.10 g).

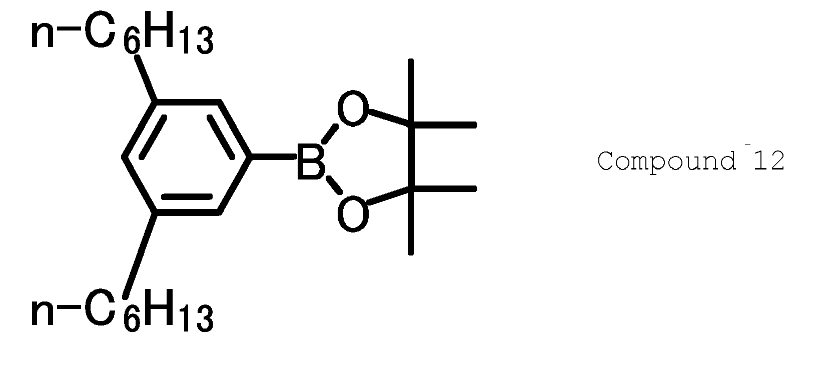

### (Synthesis of compound 13)

Under an inert atmosphere, 3,6-dibromocarbazole (13.30 g, 40.9 mmol), tetrakistriphenylphosphinepalladium (2.36 g, 2.1 mmol), the compound 12 (39.62 g, 106.4 mmol), 1,4-dioxane (157.2 g), potassium carbonate (18.66 g, 135.1 mmol) and water (62 g) were stirred at 105°C for 13 hours. To this was added diethyl ether at 25°C and the mixture was stirred, allowed to stand still giving an aqueous layer which was then removed. To the resultant oil layer was added water and the mixture was stirred, allowed to stand still to cause liquid separation giving an aqueous layer which was then removed. Then, to the resultant oil layer was added sodium carbonate and the mixture was stirred, and passed through a filter matted with silica gel. The resultant solution was concentrated under reduced pressure to obtain solid. The solid was recrystallized from ethanol, to obtain a compound 13 represented by the following formula (12.07 g, yield 45%).

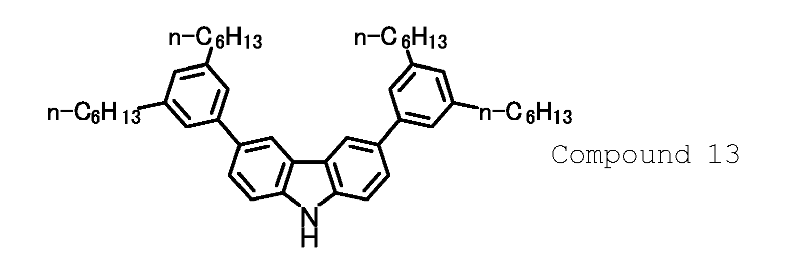

### (Synthesis of compound 14)

Under an inert atmosphere, into a three-necked flask was added the compound 13 (9.69 g, 14.8 mmol) and tetrahydrofuran (68 mL) to prepare a solution, into this was dropped n-butyllithium (1.6M hexane solution, 9.4 mL) at 0 to 5°C over a period of 30 minutes, further, the mixture was stirred at the same temperature for 1 hour to prepare a mixture D.

Then, into a mixture composed of the compound 2 (6.10 g, 14.3 mmol) and tetrahydrofuran (54 mL), the above-described mixture D was dropped at 0 to 5°C over a period of 1 hour, and the mixture was stirred at 25°C. Then, to this was added water (5.4 g) at 25°C, and the resultant solution was concentrated under reduced pressure to remove the solvent. Then, to this was added chloroform and water and the mixture was stirred, allowed to stand still giving an aqueous layer which was then removed, and the resultant oil layer was concentrated under reduced pressure to remove the solvent, obtaining solid. The solid was recrystallized from tetrahydrofuran and methanol, to obtain a compound 14 represented by the following formula (5.13 g, yield 340).

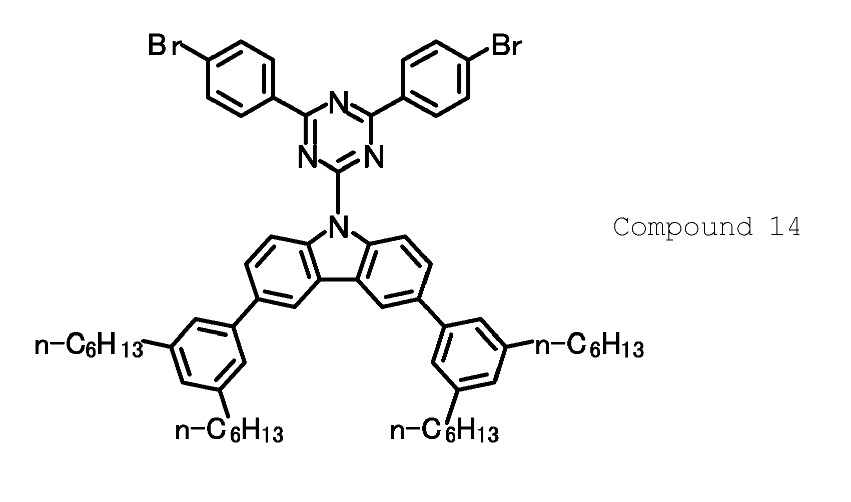

### <Comparative Example 1> (Synthesis of polymer compound 1)

Under an inert atmosphere, a compound 4 (1.47 g, 3.0 mmol) represented by the following formula: 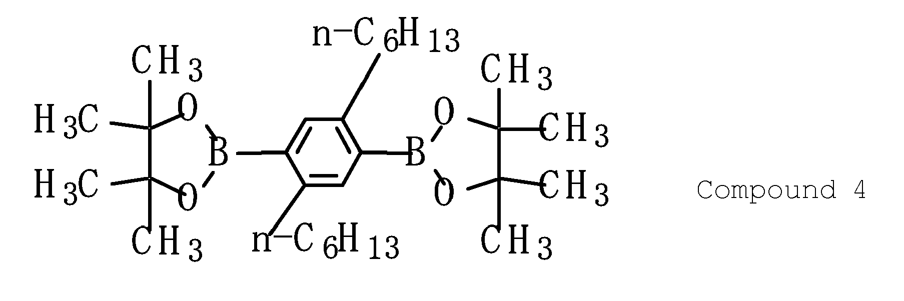 , a compound 5 (1.65 g, 3.0 mmol) represented by the following formula: 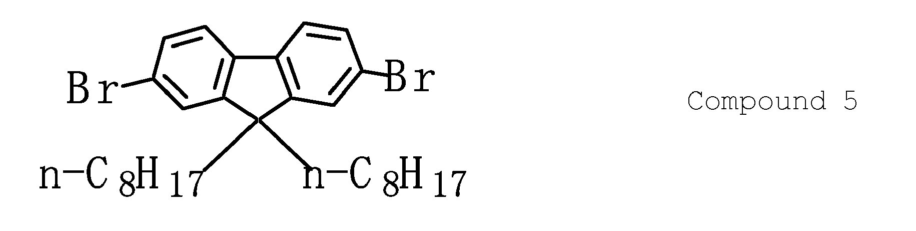 , palladium acetate (1.0 mg), tris(2-methoxyphenyl)phosphine (6.3 mg), a 20 wt% tetraethylammonium hydroxide aqueous solution (10 mL) and toluene (30 mL) were mixed, and the mixture was stirred at 105°C for 2 hours. After the reaction, phenylboric acid (366 mg), palladium acetate (1.0 mg) and tris(2-methoxyphenyl)phosphine (6.3 mg) were added, further, the mixture was stirred at 105°C for 14 hours. Then, a sodium diethyldithiacarbamate aqueous solution was added and the mixture was stirred at 80°C for 2 hours. After cooling, the mixture was washed with water (39 mL) twice, a 3% acetic acid aqueous solution (39 mL) twice and water (39 mL) twice, the resultant solution was dropped into methanol (465 mL), and filtrated to obtain a precipitate. The precipitate was dissolved in toluene (93 mL), and the solution was purified by passing through an alumina column and a silica gel column. The resultant toluene solution was dropped into methanol (465 mL), and the mixture was stirred, then, the resultant precipitate was filtrated and dried. The resultant polymer compound 1 showed a yielded amount of 1.5 g.

The polymer compound 1 had a polystyrene-equivalent number average molecular weight of 5.1×10⁴ and a polystyrene-equivalent weight average molecular weight of 1.1×10⁵.

The polymer compound 1 is a copolymer constituted of a repeating unit represented by the following formula: 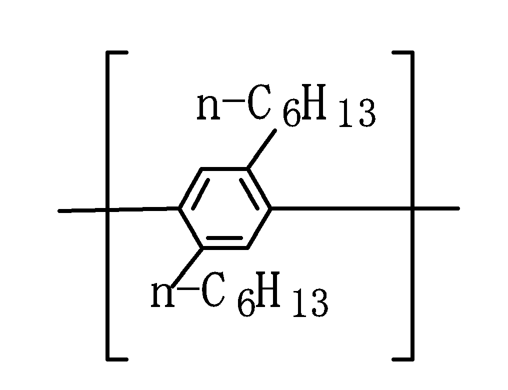 and a repeating unit represented by the following formula: 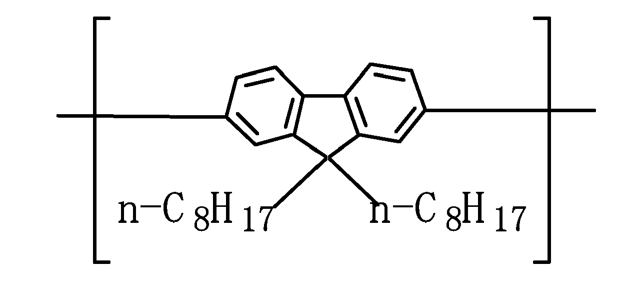 , at a molar ratio of 50:50, according to the theoretical value calculated from the charged raw materials.

### <Example 5> (Synthesis of polymer compound 2)

Under an inert atmosphere, the above-described compound 4 (1.53 g, 3.1 mmol), the above-described compound 5 (1.38 g, 2.5 mmol), the above-described compound 3 (0.41 g, 0.6 mmol), palladium acetate (1.0 mg), tris(2-methoxyphenyl)phosphine (6.5 mg), a 20 wt% tetraethylammonium hydroxide aqueous solution (10 mL) and toluene (41 mL) were mixed, and the mixture was stirred at 105°C for 2 hours. After the reaction, to this was added phenylboric acid (38 mg), palladium acetate (1.0 mg) and tris(2-methoxyphenyl)phosphine (6.4 mg), further, the mixture was stirred at 105°C for 14 hours. Then, to this was added a sodium diethyldithiacarbamate aqueous solution, and the mixture was stirred at 80°C for 2 hours. After cooling, the mixture was washed with water (40 mL) twice, a 3 wt% acetic acid aqueous solution (40 mL) twice and water (40 mL) twice. The resultant solution was dropped into methanol (472 mL), and filtrated to obtain a precipitate. This precipitate was dissolved in toluene (94 mL), and the solution was purified by passing through an alumina column and a silica gel column. The resultant toluene solution was dropped into methanol (472 mL), and the mixture was stirred, then, the resultant precipitate was filtrated and dried. The resultant polymer compound 2 showed a yielded amount of 1.8 g.

The polymer compound 2 had a polystyrene-equivalent number average molecular weight of 2.2×10⁵ and a polystyrene-equivalent weight average molecular weight of 7.7x10⁵.

The polymer compound 2 is a copolymer constituted of a repeating unit represented by the following formula: 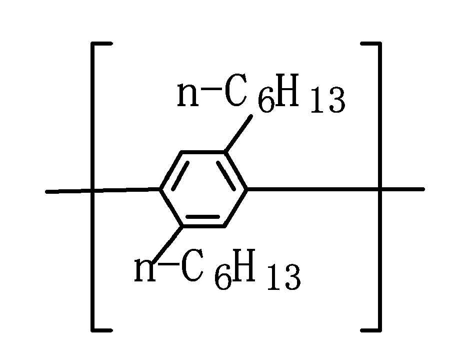 a repeating unit represented by the following formula: 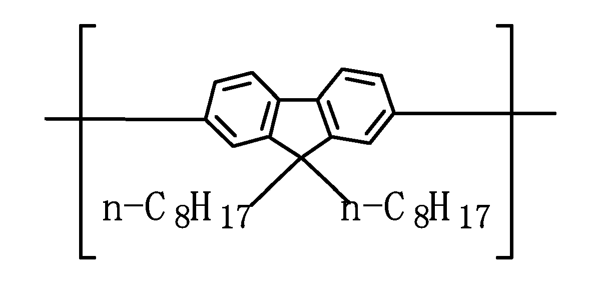 and a repeating unit represented by the following formula: 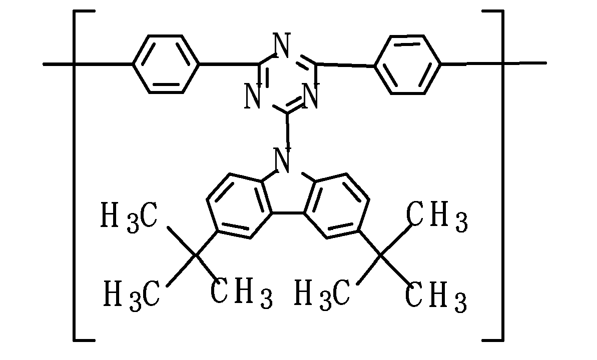 , at a molar ratio of 50:40:10, according to the theoretical value calculated from the charged raw materials.

### <Example 6> (Synthesis of polymer compound 4)

Under an inert atmosphere, the above-described compound 4 (1.4786 g, 2.97 mmol), the above-described compound 5 (1.3163 g, 2.40 mmol), the above-described compound 9 (0.4516 g, 0.60 mmol), palladium acetate (1.0 mg), tris(2-methoxyphenyl)phosphine (6.3 mg), a 20 wt% tetraethylammonium hydroxide aqueous solution (10 mL) and toluene (41 mL) were mixed, and the mixture was stirred at 105°C for 2.5 hours. After the reaction, to this was added phenylboric acid (36 mg), palladium acetate (1.0 mg) and tris(2-methoxyphenyl)phosphine (6.4 mg), further, the mixture was stirred at 105°C for 18 hours. Then, to this was added a sodium diethyldithiacarbamate aqueous solution, and the mixture was stirred at 80°C for 2 hours. After cooling, the mixture was washed with water (40 mL) twice, a 3 wt% acetic acid aqueous solution (40 mL) twice and water (40 mL) twice. The resultant solution was dropped into methanol (466 mL), and filtrated to obtain a precipitate. This precipitate was dissolved in toluene (94 mL), and the solution was purified by passing through an alumina column and a silica gel column. The resultant toluene solution was dropped into methanol (700 mL), and the mixture was stirred, then, the resultant precipitate was filtrated and dried. The resultant polymer compound 4 showed a yielded amount of 1.5 g. The polymer compound 4 had a polystyrene-equivalent number average molecular weight of 1.2×10⁵ and a polystyrene-equivalent weight average molecular weight of 4.0×10⁵.

The polymer compound 4 is a copolymer constituted of a repeating unit represented by the following formula: 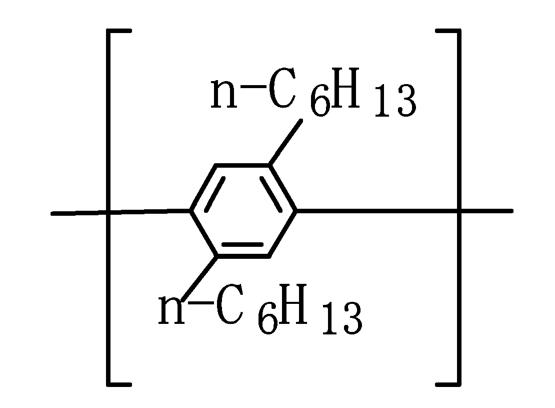 a repeating unit represented by the following formula: 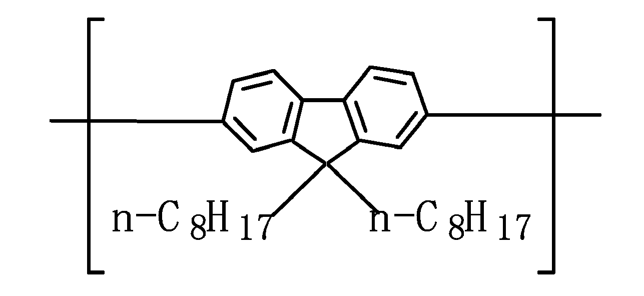 and a repeating unit represented by the following formula: 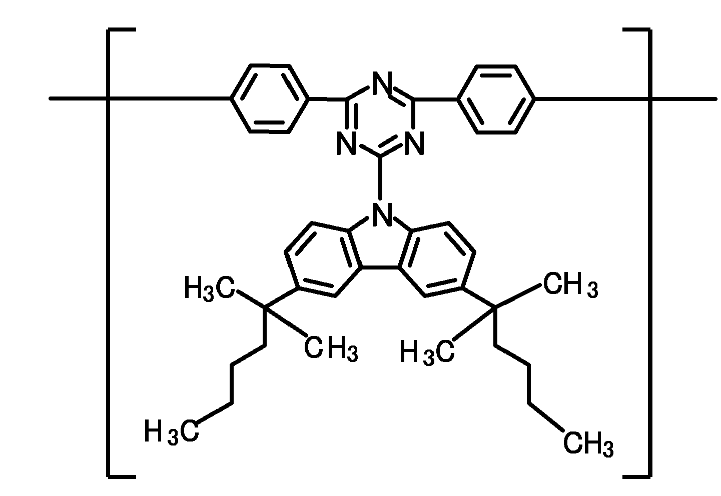 , at a molar ratio of 50:40:10, according to the theoretical value calculated from the charged raw materials.

### <Synthesis Example 1> (Synthesis of polymer compound 3)

Under an inert atmosphere, a compound 6 (5.20 g) represented by the following formula: 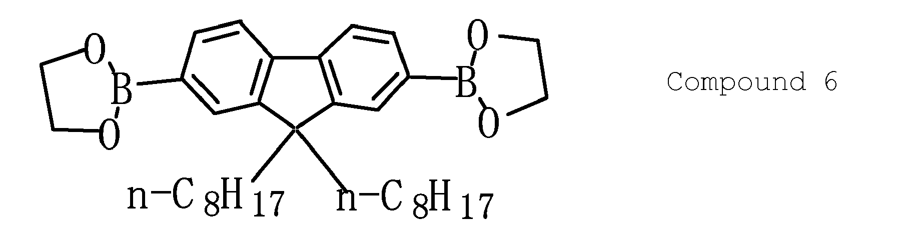 , a compound 7 (5.42 g) represented by the following formula: 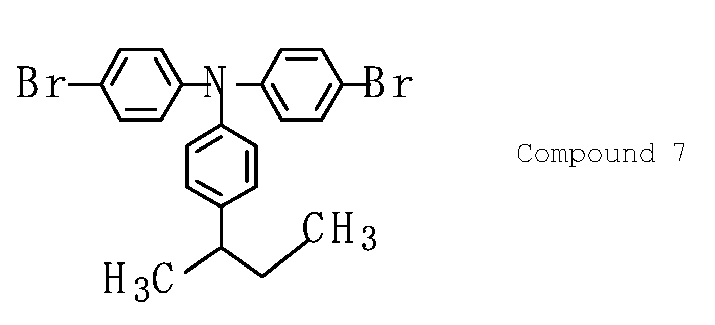 , palladium acetate (2.2 mg), tris(2-methylphenyl)phosphine (15.1 mg), trioctylmethylammonium chloride (trade name: Aliquat336 (manufactured by Aldrich), 0.91 g) and toluene (70 mL) were mixed, and the mixture was heated at 105°C. Into the resultant solution was dropped a 2M sodium carbonate aqueous solution (19 mL) and the mixture was refluxed for 4 hours. After the reaction, to this was added phenylboric acid (121 mg), further, the mixture was refluxed for 3 hours. Then, to this was added a sodium diethyldithiacarbamate aqueous solution, and the mixture was stirred at 80°C for 2 hours. After cooling, the resultant reaction liquid was washed with water (60 mL) three times, a 3 wt% acetic acid aqueous solution (60 mL) four times and water (60 mL) three times, and the resultant toluene solution was purified by passing through an alumina column and a silica gel column. The resultant toluene solution was dropped into methanol (3L), and the mixture was stirred, then, the resultant precipitate was filtrated and dried. This precipitate (hereinafter, referred to as "polymer compound 3") showed a yielded amount of 5.25 g.

The polymer compound 3 had a polystyrene-equivalent number average molecular weight of 1.2×10⁵ and a polystyrene-equivalent weight average molecular weight of 2.6×10⁵.

The polymer compound 3 is a copolymer constituted of a repeating unit represented by the following formula: 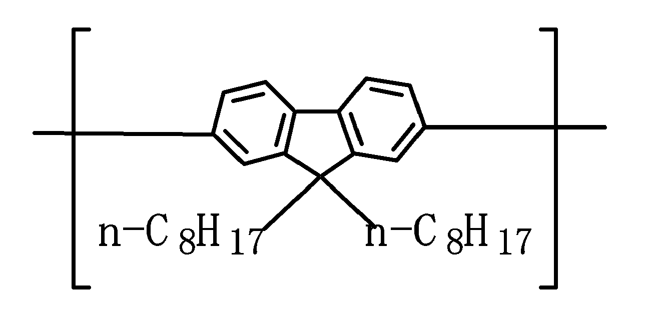 and a repeating unit represented by the following formula: 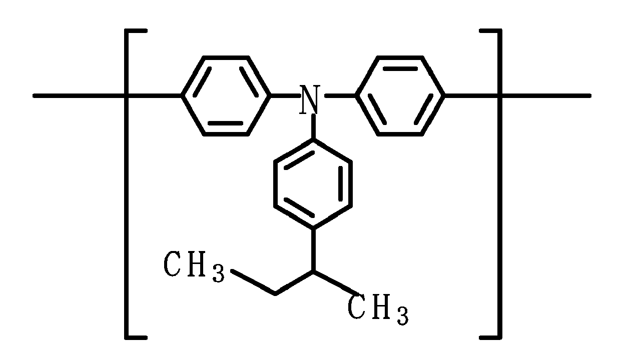 , at a molar ratio of 50:50, according to the theoretical value calculated from the charged raw materials.

### <Comparative Example 2> (Preparation of solution S1)

The polymer compound 1 and an iridium complex (Manufactured by American Dye Source, Inc., trade name: ADS066 GE) (hereinafter, referred to as "ADS066 GE") were dissolved in xylene (manufactured by Kanto Chemical Co., Inc., grade for electronic industry) so that the weight ratio thereof was 95:5. In this procedure, the solution was prepared so that the total weight of the polymer compound 1 and ADS066 GE was 1.6 wt% with respect to the weight of the whole solution (hereinafter, this solution is referred to as "solution S1").

### <Example 7> (Preparation of solution S2)

The polymer compound 2 and ADS066 GE were dissolved in xylene (manufactured by Kanto Chemical Co., Inc., grade for electronic industry) so that the weight ratio thereof was 95:5. In this procedure, the solution was prepared so that the total weight of the polymer compound 2 and ADS066 GE was 0.9 wt% with respect to the weight of the whole solution (hereinafter, this solution is referred to as "solution S2").

### <Example 8> (Preparation of solution S4)

The polymer compound 4 and ADS066 GE were dissolved in xylene (manufactured by Kanto Chemical Co., Inc., grade for electronic industry) so that the weight ratio thereof was 95:5. In this procedure, the solution was prepared so that the total weight of the polymer compound 4 and ADS066 GE was 1.4 wt% with respect to the weight of the whole solution (hereinafter, this solution is referred to as "solution S4").

### <Comparative Example 3> (Fabrication of light emitting device 1)

First, the polymer compound 3 was dissolved in xylene (manufactured by Kanto Chemical Co., Inc., grade for electronic industry). In this procedure, the solution was prepared so that the concentration of the polymer compound 3 was 0.7 wt% with respect to the weight of the whole solution (hereinafter, this solution is referred to as "solution S3"). Next, a solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S1 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 1. The device constitution was ITO/BaytronP/polymer compound 3/mixture of polymer compound 1 and ADS066GE/Ba/Al. After the degree of vacuum reached 1×10⁻⁴ Pa or less, vapor-deposition of a metal was initiated.

When voltage was applied on the light emitting device 1, electroluminescence (EL) of green emission was observed. At a luminance of 1000 cd/m², efficiency was 3.0 cd/A, the voltage under this condition was 18.0 V, and the external quantum yield was 0.94%. When the initial luminance was 1000 cd/m², the luminance half life was 0.3 hours.

### <Example 9> (Fabrication of light emitting device 2)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S2 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 2. The device constitution was ITO/BaytronP/polymer compound 3/mixture of polymer compound 2 and ADS066GE/Ba/Al. After the degree of vacuum reached 1×10⁻⁴ Pa or less, vapor-deposition of a metal was initiated.

When voltage was applied on the light emitting device 2, electroluminescence (EL) of green emission was observed. At a luminance of 1000 cd/m², efficiency was 4.7 cd/A, the voltage under this condition was 9.5 V, and the external quantum yield was 1.48%. When the initial luminance was 1000 cd/m², the luminance half life was 1.2 hours.

### <Example 10> (Fabrication of light emitting device 3)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S4 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 3. The device constitution was ITO/BaytronP/polymer compound 3/mixture of polymer compound 4 and ADS066GE/Ba/Al. After the degree of vacuum reached 1×10⁻⁴ Pa or less, vapor-deposition of a metal was initiated.

When voltage was applied on the light emitting device 3, electroluminescence (EL) of green emission was observed. At a luminance of 1000 cd/m², efficiency was 4.4 cd/A, the voltage under this condition was 9.4 V, and the external quantum yield was 1.42%. When the initial luminance was 1000 cd/m², the luminance half life was 1.1 hours.

### <Comparative Example 4> (Preparation of solution S5)

The polymer compound 1 and an iridium complex represented by the following formula: 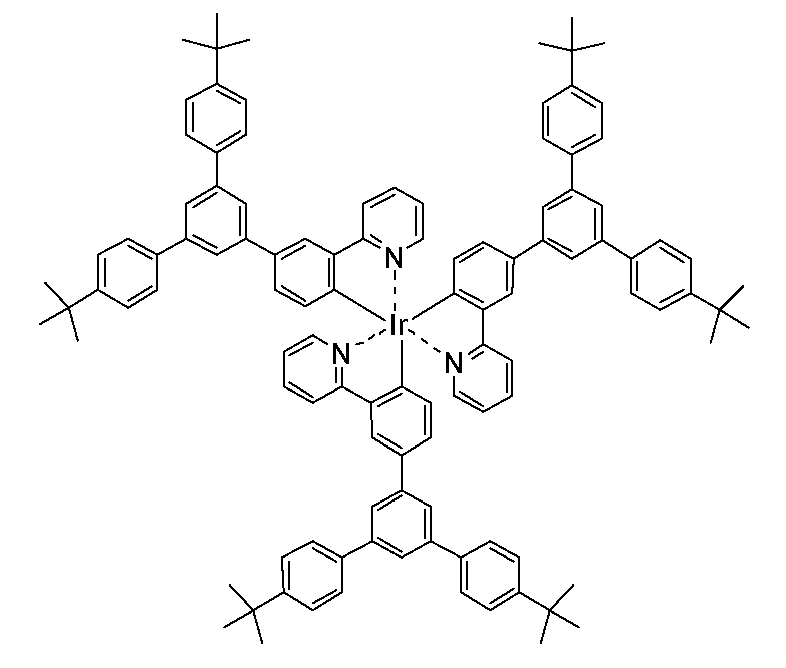 (hereinafter, referred to as "iridium complex A") were dissolved in xylene (manufactured by Kanto Chemical Co., Inc., grade for electronic industry) so that the weight ratio thereof was 70:30. In this procedure, the solution was prepared so that the total weight of the polymer compound 1 and the iridium complex A was 1.1 wt% with respect to the weight of the whole solution (hereinafter, this solution is referred to as "solution S5").

### <Example 11> (Preparation of solution S6)

The polymer compound 4 and the iridium complex A were dissolved in xylene (manufactured by Kanto Chemical Co., Inc., grade for electronic industry) so that the weight ratio thereof was 70:30. In this procedure, the solution was prepared so that the total weight of the polymer compound 4 and the iridium complex A was 1.6 wt% with respect to the weight of the whole solution (hereinafter, this solution is referred to as "solution S6").

### <Comparative Example 5> (Fabrication of light emitting device 4)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S5 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 4. The device constitution was ITO/BaytronP/polymer compound 3/mixture of polymer compound 1 and iridium complex A/Ba/Al. After the degree of vacuum reached 1×10⁻⁴ Pa or less, vapor-deposition of a metal was initiated.

When voltage was applied on the light emitting device 4, electroluminescence (EL) of green emission was observed. At a luminance of 1000 cd/m², efficiency was 40.3 cd/A, the voltage under this condition was 8.8 V, and the external quantum yield was 11.20%. When the initial luminance was 4000 cd/m², the luminance half life was 5.1 hours.

### <Example 12> (Fabrication of light emitting device 5)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S6 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 5. The device constitution was ITO/BaytronP/polymer compound 3/mixture of polymer compound 4 and iridium complex A/Ba/Al. After the degree of vacuum reached 1×10⁻⁴ Pa or less, vapor-deposition of a metal was initiated.

When voltage was applied on the light emitting device 5, electroluminescence (EL) of green emission was observed. At a luminance of 1000 cd/m², efficiency was 38.5 cd/A, the voltage under this condition was 6.5 V, and the external quantum yield was 10.7%. When the initial luminance was 4000 cd/m², the luminance half life was 27.0 hours.

### <Comparative Example 6> (Synthesis of polymer compound 5)

Under an inert atmosphere, the above-described compound 4 (1.4771 g, 2.96 mmol), the above-described compound 5 (1.3163 g, 2.40 mmol), the above-described compound 7 (0.2761 g, 0.60 mmol), palladium acetate (1.1 mg), tris(2-methoxyphenyl)phosphine (6.3 mg), a 20 wt% tetraethylammonium hydroxide aqueous solution (10 mL) and toluene (41 mL) were mixed, and the mixture was stirred at 105°C for 3.5 hours. After the reaction, to this was added phenylboric acid (37 mg), palladium acetate (1.1 mg) and tris(2-methoxyphenyl)phosphine (6.4 mg), further, the mixture was stirred at 105°C for 15 hours. Then, to this was added a sodium diethyldithiacarbamate aqueous solution, and the mixture was stirred at 80°C for 2 hours. After cooling, the mixture was washed with water (40 mL) twice, a 3 wt% acetic acid aqueous solution (40 mL) twice and water (40 mL) twice. The resultant solution was dropped into methanol (500 mL), and filtrated to obtain a precipitate. This precipitate was dissolved in toluene (100 mL), and the solution was purified by passing through an alumina column and a silica gel column. The resultant toluene solution was dropped into methanol (500 mL), and the mixture was stirred, then, the resultant precipitate was filtrated and dried. The resultant polymer compound 5 showed a yielded amount of 1.6 g. The polymer compound 5 had a polystyrene-equivalent number average molecular weight of 1.0×10⁵ and a polystyrene-equivalent weight average molecular weight of 3.2×10⁵.

The polymer compound 5 is a copolymer constituted of a repeating unit represented by the following formula: 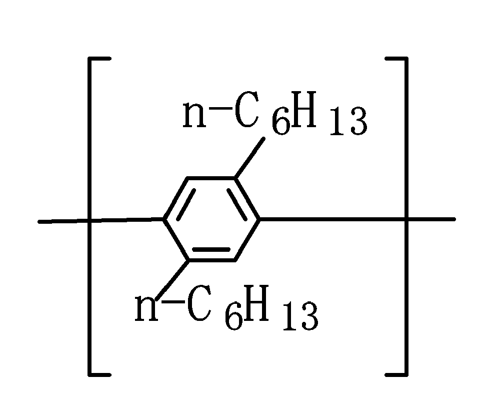 a repeating unit represented by the following formula: 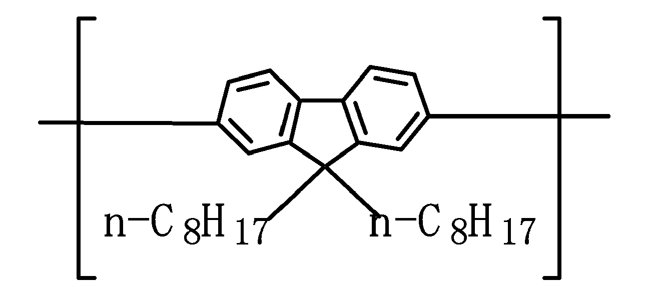 and a repeating unit represented by the following formula: 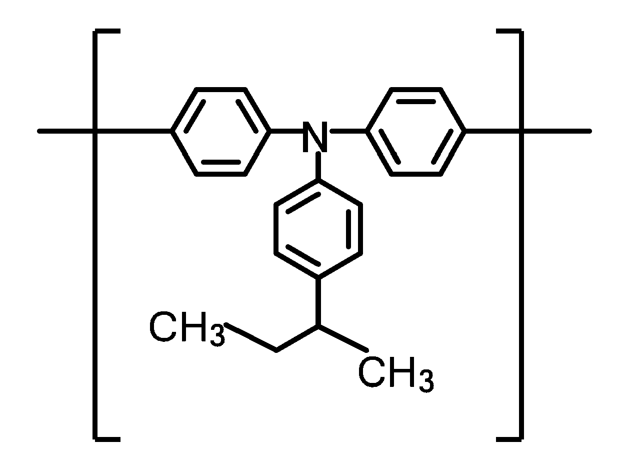 , at a molar ratio of 50:40:10, according to the theoretical value calculated from the charged raw materials.

### <Example 13> (Synthesis of polymer compound 6)

Under an inert atmosphere, the above-described compound 4 (1.4771 g, 2.96 mmol), the above-described compound 5 (0.9871 g, 1.80 mmol), the above-described compound 3 (0.4010 g, 0.60 mmol), the above-described compound 7 (0.2756 g, 0.60 mmol), palladium acetate (1.1 mg), tris(2-methoxyphenyl)phosphine (6.3 mg), a 20 wt% tetraethylammonium hydroxide aqueous solution (10 mL) and toluene (41 mL) were mixed, and the mixture was stirred at 105°C for 2.5 hours. After the reaction, to this was added phenylboric acid (36 mg), palladium acetate (1.1 mg) and tris(2-methoxyphenyl)phosphine (6.4 mg), further, the mixture was stirred at 105°C for 15 hours. Then, to this was added a sodium diethyldithiacarbamate aqueous solution, and the mixture was stirred at 80°C for 2 hours. After cooling, the mixture was washed with water (40 mL) twice, a 3 wt% acetic acid aqueous solution (40 mL) twice and water (40 mL) twice. The resultant solution was dropped into methanol (500 mL), and filtrated to obtain a precipitate. This precipitate was dissolved in toluene (100 mL), and the solution was purified by passing through an alumina column and a silica gel column. The resultant toluene solution was dropped into methanol (500 mL), and the mixture was stirred, then, the resultant precipitate was filtrated and dried. The resultant polymer compound 6 showed a yielded amount of 1.6 g. The polymer compound 6 had a polystyrene-equivalent number average molecular weight of 5.9×10⁴ and a polystyrene-equivalent weight average molecular weight of 1.6×10⁵.

The polymer compound 6 is a copolymer constituted of a repeating unit represented by the following formula: 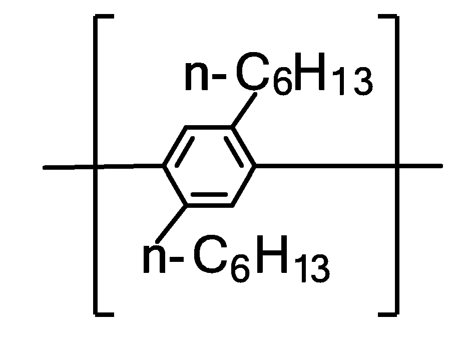 a repeating unit represented by the following formula: 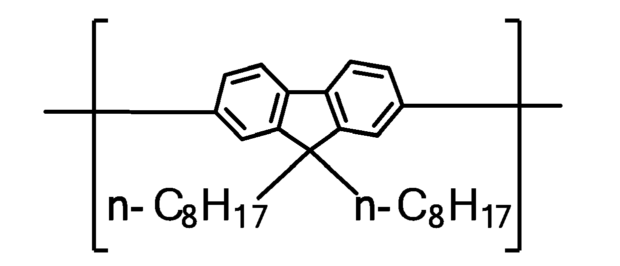 a repeating unit represented by the following formula: 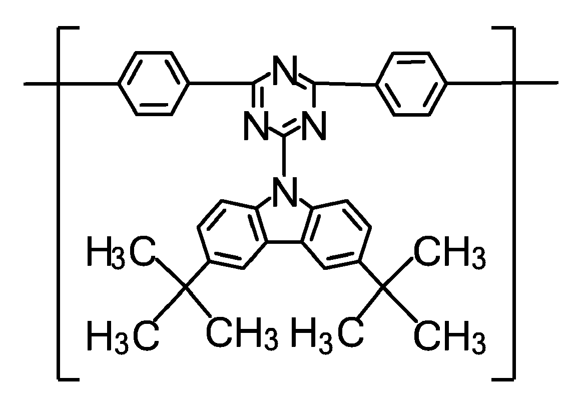 and a repeating unit represented by the following formula: 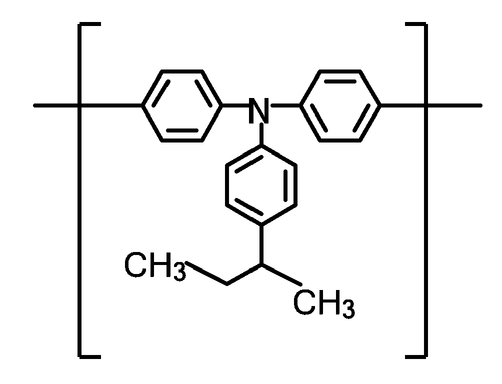 , at a molar ratio of 50:30:10:10, according to the theoretical value calculated from the charged raw materials.

### <Comparative Example 7> (Preparation of solution S7)

The polymer compound 5 and ADS066 GE were dissolved in xylene (manufactured by Kanto Chemical Co., Inc., grade for electronic industry) so that the weight ratio thereof was 95:5. In this procedure, the solution was prepared so that the total weight of the polymer compound 5 and ADS066 GE was 1.5 wt% with respect to the weight of the whole solution (hereinafter, this solution is referred to as "solution S7").

### <Example 14> (Preparation of solution S8)

The polymer compound 6 and ADS066 GE were dissolved in xylene (manufactured by Kanto Chemical Co., Inc., grade for electronic industry) so that the weight ratio thereof was 95:5. In this procedure, the solution was prepared so that the total weight of the polymer compound 6 and ADS066 GE was 1.8 wt% with respect to the weight of the whole solution (hereinafter, this solution is referred to as "solution S8").

### <Comparative Example 8> (Fabrication of light emitting device 6)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S7 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 6. The device constitution was ITO/BaytronP/polymer compound 3/mixture of polymer compound 5 and ADS066GE/Ba/Al. After the degree of vacuum reached 1×10⁻⁴ Pa or less, vapor-deposition of a metal was initiated.

When voltage was applied on the light emitting device 6, electroluminescence (EL) of green emission was observed. At a luminance of 1000 cd/m², efficiency was 21.7 cd/A, the voltage under this condition was 13.8 V, and the external quantum yield was 6.68%. When the initial luminance was 1000 cd/m², the luminance half life was 0.7 hours.

### <Example 15> (Fabrication of light emitting device 7)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S8 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 7. The device constitution was ITO/BaytronP/polymer compound 3/mixture of polymer compound 6 and ADS066GE/Ba/Al. After the degree of vacuum reached 1×10⁻⁴ Pa or less, vapor-deposition of a metal was initiated.

When voltage was applied on the light emitting device 7, electroluminescence (EL) of green emission was observed. At a luminance of 1000 cd/m², efficiency was 9.7 cd/A, the voltage under this condition was 7.5 V, and the external quantum yield was 3.06%. When the initial luminance was 1000 cd/m², the luminance half life was 50.7 hours.

### <Comparative Example 9> (Preparation of solution S9)

The polymer compound 5 the iridium complex A were dissolved in xylene (manufactured by Kanto Chemical Co., Inc., grade for electronic industry) so that the weight ratio thereof was 70:30. In this procedure, the solution was prepared so that the total weight of the polymer compound 5 and the iridium complex A was 1.7 wt% with respect to the weight of the whole solution (hereinafter, this solution is referred to as "solution S9").

### <Example 16> (Preparation of solution S10)

The polymer compound 6 and the iridium complex A were dissolved in xylene (manufactured by Kanto Chemical Co., Inc., grade for electronic industry) so that the weight ratio thereof was 70:30. In this procedure, the solution was prepared so that the total weight of the polymer compound 6 and the iridium complex A was 2.0 wt% with respect to the weight of the whole solution (hereinafter, this solution is referred to as "solution S10").

### <Comparative Example 10> (Fabrication of light emitting device 8)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S9 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 8. The device constitution was ITO/BaytronP/polymer compound 3/mixture of polymer compound 5 and iridium complex A/Ba/Al. After the degree of vacuum reached 1×10⁻⁴ Pa or less, vapor-deposition of a metal was initiated.

When voltage was applied on the light emitting device 8, electroluminescence (EL) of green emission was observed. At a luminance of 1000 cd/m², efficiency was 40.3 cd/A, the voltage under this condition was 8.6 V, and the external quantum yield was 11.22%. When the initial luminance was 4000 cd/m², the luminance half life was 16.6 hours.

### <Example 17> (Fabrication of light emitting device 9)

A solution of poly(3,4-ethylenedioxythiophene)/polystyrenesulfonic acid (manufactured by Bayer, trade name: BaytronP AI4083) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the solution S3 was spin-coated to form a film having a thickness of about 20 nm, and the film was dried at 180°C for 60 minutes on a hot plate under a nitrogen atmosphere. Next, the solution S10 was spin-coated to form a film having a thickness of about 80 nm, and this was dried at 130°C for 10 minutes under a nitrogen atmosphere, then, as a cathode, barium was vapor-deposited with a thickness of about 5 nm, finally, aluminum was vapor-deposited with a thickness of about 80 nm, fabricating a light emitting device 9. The device constitution was ITO/BaytronP/polymer compound 3/mixture of polymer compound 6 and iridium complex A/Ba/Al. After the degree of vacuum reached 1×10⁻⁴ Pa or less, vapor-deposition of a metal was initiated.

When voltage was applied on the light emitting device 9, electroluminescence (EL) of green emission was observed. At a luminance of 1000 cd/m², efficiency was 41.6 cd/A, the voltage under this condition was 6.5 V, and the external quantum yield was 11.62%. When the initial luminance was 4000 cd/m², the luminance half life was 50.6 hours.

### Industrial Applicability

The polymer compound of the present invention is a polymer compound which, when used for fabrication of an organic electroluminescent device, gives an organic electroluminescent device showing long luminance half life. Further, the polymer compound of the present invention is useful also as an electronic part material such as a light emitting material, a charge transporting material or the like, thus, it is also useful for backlight of a liquid crystal display, a curved or flat light source for illumination, a segment type display device, a dot matrix flat panel display or the like.

## Claims

1. A polymer compound having a repeating unit represented by the following formula (1): 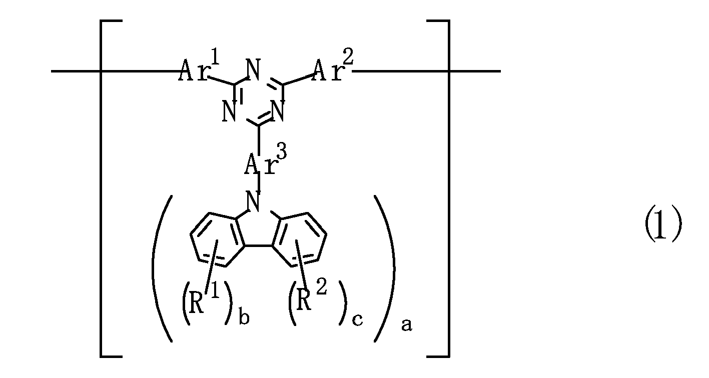 (wherein Ar¹ and Ar² represent each independently an unsubstituted or substituted arylene group or an unsubstituted or substituted di-valent aromatic heterocyclic group, Ar³ represents a single bond, an unsubstituted or substituted (a+1)-valent aromatic hydrocarbon group or an unsubstituted or substituted (a+1)-valent aromatic heterocyclic group. R¹ and R² represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. a represents an integer of 1 or more, with the proviso that a is 1 when Ar³ is a single bond. b and c represent each independently an integer of 0 to 4. When there exist a plurality of R¹s, these may be the same or different. When there exist a plurality of R²s, these may be the same or different. When there exist a plurality of b's, these may be the same or different. When there exist a plurality of c's, these may be the same or different.).

2. The polymer compound according to Claim 1, wherein the repeating unit represented by said formula (1) is a repeating unit represented by the following formula (4): 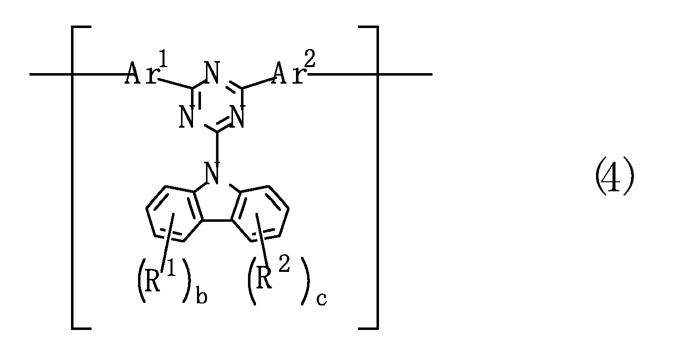 (wherein Ar¹, Ar², R¹, R², b and c have the same meaning as described above.).

3. The polymer compound according to Claim 2, wherein the repeating unit represented by said formula (4) is a repeating unit represented by the following formula (5): 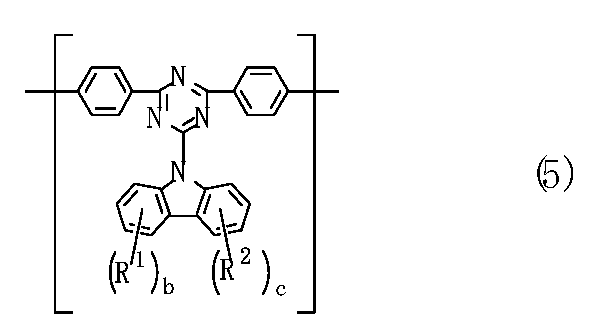 (wherein R¹, R², b and c have the same meaning as described above.).

4. The polymer compound according to any one of Claims 1 to 3, wherein the polymer compound further contains at least one repeating unit selected from the group consisting of a repeating unit represented by the following formula (2) and a repeating unit represented by the following formula (3):
-(Ar⁴)- (2)
(wherein Ar⁴ represents an unsubstituted or substituted arylene group or an unsubstituted or substituted di-valent aromatic heterocyclic group.) 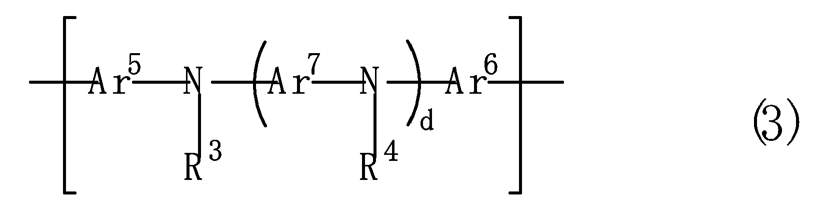 (wherein Ar⁵, Ar⁶ and Ar⁷ represent each independently an unsubstituted or substituted arylene group, an unsubstituted or substituted di-valent aromatic heterocyclic group or an unsubstituted or substituted di-valent group composed of two aromatic rings linked via a single bond. R³ and R⁴ represent each independently a hydrogen atom, an unsubstituted or substituted alkyl group, an unsubstituted or substituted aryl group or an unsubstituted or substituted mono-valent heterocyclic group. d represents 0 or 1.).

5. The polymer compound according to Claim 4, wherein Ar⁴ in said formula (2) represents an unsubstituted or substituted phenylene group, an unsubstituted or substituted naphthalenediyl group, an unsubstituted or substituted anthracenediyl group, an unsubstituted or substituted phenanthrenediyl group, an unsubstituted or substituted naphthacenediyl group, an unsubstituted or substituted fluorenediyl group, an unsubstituted or substituted pyrenediyl group, an unsubstituted or substituted perylenediyl group, an unsubstituted or substituted pyridinediyl group, an unsubstituted or substituted thiophenediyl group, an unsubstituted or substituted furandiyl group, an unsubstituted or substituted quinolinediyl group, an unsubstituted or substituted isoquinolinediyl group, an unsubstituted or substituted quinoxalinediyl group, an unsubstituted or substituted benzo[1,2,5]thiadiazolediyl group, an unsubstituted or substituted benzothiazolediyl group, an unsubstituted or substituted carbazolediyl group, an unsubstituted or substituted phenoxazinediyl group, an unsubstituted or substituted phenothiazinediyl group, or an unsubstituted or substituted dibenzosilolediyl group.

6. The polymer compound according to Claim 5, wherein Ar⁴ in said formula (2) represents a group represented by the following formula (6), (7), (8), (9) or (10) : 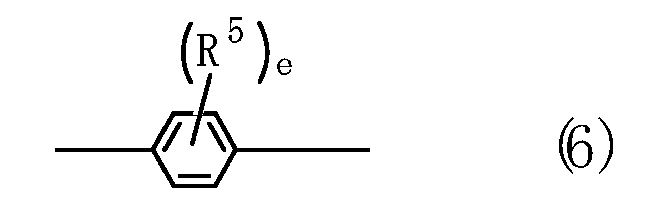 (wherein R⁵ represents an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. e represents an integer of 0 to 4. When there exist a plurality of R⁵s, these may be the same or different.) 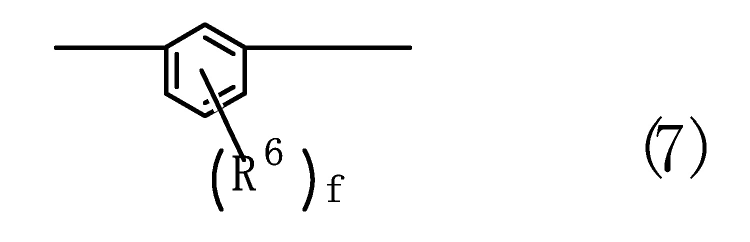 (wherein R⁶ represents an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. f represents an integer of 0 to 4. When there exist a plurality of R⁶s, these may be the same or different.) 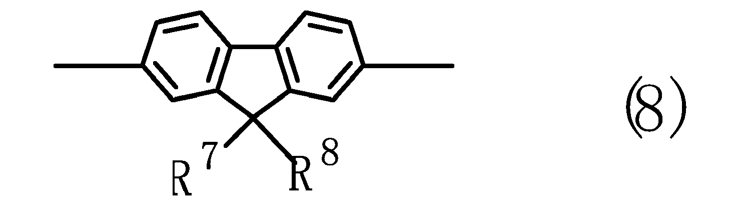 (wherein R⁷ and R⁸ represent each independently a hydrogen atom, an unsubstituted or substituted alkyl group, an unsubstituted or substituted aryl group or an unsubstituted or substituted mono-valent heterocyclic group.) 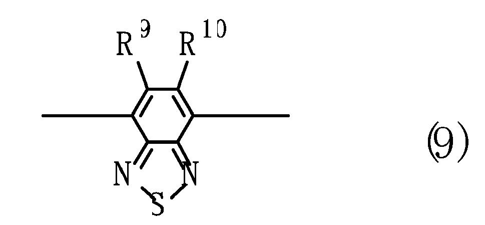 (wherein R⁹ and R¹⁰ represent each independently a hydrogen atom, an unsubstituted or substituted alkyl group, an unsubstituted or substituted alkoxy group, an unsubstituted or substituted aryl group or an unsubstituted or substituted mono-valent heterocyclic group.) 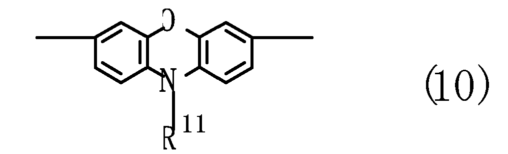 (wherein R¹¹ represents a hydrogen atom, an unsubstituted or substituted alkyl group, an unsubstituted or substituted aryl group or an unsubstituted or substituted mono-valent heterocyclic group.).

7. The polymer compound according to any one of Claims 4 to 6, wherein Ar⁵, Ar⁶ and Ar⁷ in said formula (3) represent each independently an unsubstituted or substituted arylene group.

8. The polymer compound according to any one of Claims 4 to 7, wherein the total molar amount of a repeating unit represented by said formula (1), a repeating unit represented by said formula (2) and a repeating unit represented by said formula (3) with respect to the total molar amount of all repeating units is 90 to 100%.

9. A composition comprising at least one material selected from the group consisting of a hole transporting material, an electron transporting material and a light emitting material, and the polymer compound according to any one of Claims 1 to 8.

10. A solution comprising the polymer compound according to any one of Claims 1 to 8 and a solvent.

11. A film comprising the polymer compound according to any one of Claims 1 to 8.

12. A light emitting device having electrodes consisting of an anode and a cathode, and an organic layer containing the polymer compound according to any one of Claims 1 to 8 disposed between the electrodes.

13. A method of producing a polymer compound having a repeating unit represented by the following (1), comprising condensation-polymerizing a compound represented by the following formula (a): 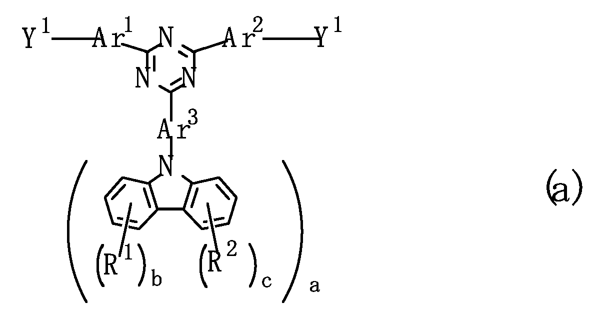 (wherein Ar¹ and Ar² represent each independently an unsubstituted or substituted arylene group or an unsubstituted or substituted di-valent aromatic heterocyclic group, Ar³ represents a single bond, an unsubstituted or substituted (a+1)-valent aromatic hydrocarbon group or an unsubstituted or substituted (a+1)-valent aromatic heterocyclic group. R¹ and R² represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a halogen atom, an unsubstituted or substituted carboxyl group or a cyano group. a represents an integer of 1 or more, with the proviso that a is 1 when Ar³ is a single bond. b and c represent each independently an integer of 0 to 4. When there exist a plurality of R¹s, these may be the same or different. When there exist a plurality of R²s, these may be the same or different. When there exist a plurality of bs, these may be the same or different. When there exist a plurality of cs, these may be the same or different. Y¹ represents a halogen atom, a methoxy group, a borate residue, a boric acid residue, a group represented by the following formula (a-1), a group represented by the following formula (a-2), a group represented by the following formula (a-3) or a group represented by the following formula (a-4). A plurality of Y¹s may be the same or different.) 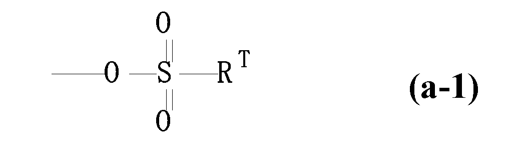 (wherein R^{T} represents an unsubstituted or substituted alkyl group or an unsubstituted or substituted aryl group.)
-MgX_{A} **(a-2)**
(wherein X_{A} represents a halogen atom.)
-ZnX_{A} **(a-3)**
(wherein X_{A} represents the same meaning as described above.)
-Sn(R^{T})₃ **(a-4)**
(wherein R^{T} represents the same meaning as described above. A plurality of R^{T}S may be mutually the same or different.) 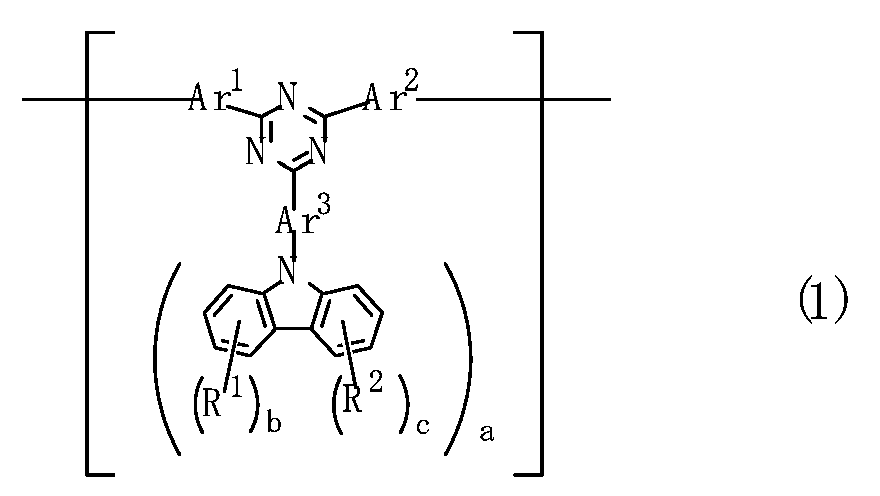 (wherein Ar¹, Ar², Ar³, R¹, R², a, b and c represent the same meaning as described above.).

14. A compound represented by the following formula (a') : 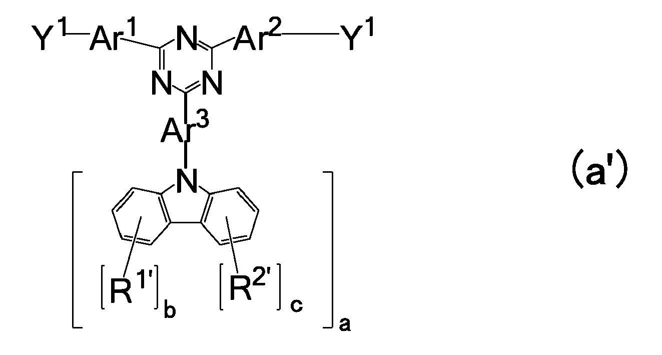 (wherein Ar¹ and Ar² represent each independently an unsubstituted or substituted arylene group or an unsubstituted or substituted di-valent aromatic heterocyclic group, Ar³ represents a single bond, an unsubstituted or substituted (a+1)-valent aromatic hydrocarbon group or an unsubstituted or substituted (a+1)-valent aromatic heterocyclic group. R¹' and R²' represent each independently an unsubstituted or substituted alkyl group, an unsubstituted or substituted alkoxy group, an unsubstituted or substituted aryl group, an unsubstituted or substituted aryloxy group, an unsubstituted or substituted mono-valent heterocyclic group, an unsubstituted or substituted amino group, an unsubstituted or substituted silyl group, a chlorine atom, a bromine atom, an iodine atom, an unsubstituted or substituted carboxyl group or a cyano group. a represents an integer of 1 or more, with the proviso that a is 1 when Ar³ is a single bond. b and c represent each independently an integer of 0 to 4. When there exist a plurality of R¹'s, these may be the same or different. When there exist a plurality of R²'s, these may be the same or different. When there exist a plurality of b's, these may be the same or different. When there exist a plurality of c's, these may be the same or different. Y¹ represents a halogen atom, a methoxy group, a borate residue, a boric acid residue, a group represented by the following formula (a-1), a group represented by the following formula (a-2), a group represented by the following formula (a-3) or a group represented by the following formula (a-4). A plurality of Y¹S may be the same or different.) 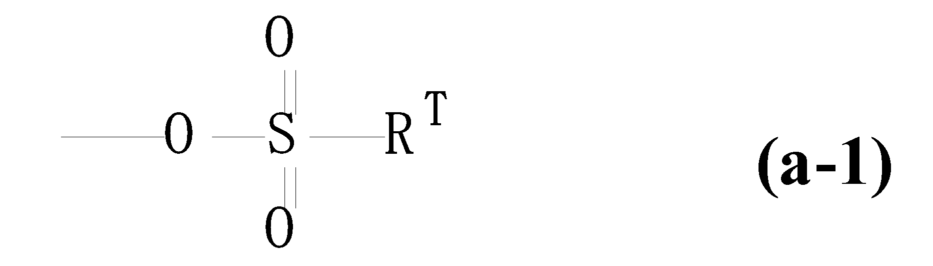 (wherein R^{T} represents an unsubstituted or substituted alkyl group or an unsubstituted or substituted aryl group.)
-MgX_{A} **(a-2)**
(wherein X_{A} represents a halogen atom.)
-ZnX_{A} **(a-3)**
(wherein X_{A} represents the same meaning as described above.)
Sn(R^{T})₃ **(a-4)**
(wherein R^{T} represents the same meaning as described above. A plurality of R^{T}s may be mutually the same or different.).
